(19) Europäisches Patentamt / European Patent Office / Office européen des brevets

(11) **EP 3 391 411 B1**

(12) **EUROPEAN PATENT SPECIFICATION**

(45) Date of publication and mention
of the grant of the patent:
**21.02.2024 Bulletin 2024/08**

(21) Application number: **16874840.8**

(22) Date of filing: **14.12.2016**

(51) International Patent Classification (IPC):
*H01L 33/50* (2010.01)        *H01L 25/075* (2006.01)
*F21K 9/232* (2016.01)        *F21Y 115/10* (2016.01)
*F21Y 103/33* (2016.01)        *F21Y 107/00* (2016.01)

(52) Cooperative Patent Classification (CPC):
**H01L 25/0753; F21K 9/232;** F21Y 2107/00;
F21Y 2115/15; H01L 33/501; H01L 33/502;
H01L 33/56; H01L 2224/48137; H01L 2933/0091

(86) International application number:
**PCT/CN2016/109891**

(87) International publication number:
**WO 2017/101783 (22.06.2017 Gazette 2017/25)**

(54) **LED FILAMENT**

LED-FILAMENT

FILAMENT DE DIODE ÉLECTROLUMINESCENTE (DEL)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: 19.12.2015  CN 201510966906
22.01.2016  CN 201610041667
27.04.2016  CN 201610272153
29.04.2016  CN 201610281600
03.06.2016  CN 201610394610
07.07.2016  CN 201610544049
22.07.2016  CN 201610586388
01.11.2016  CN 201610936171
06.12.2016  CN 201611108722

(43) Date of publication of application:
**24.10.2018 Bulletin 2018/43**

(73) Proprietor: **Jiaxing Super Lighting Electric
Appliance Co., Ltd.**
**Jiaxing, Zhejiang 314013 (CN)**

(72) Inventors:
• **JIANG, Tao**
**Jiaxing**
**Zhejiang 314013 (CN)**
• **LI, Liqin**
**Jiaxing**
**Zhejiang 314013 (CN)**

(74) Representative: **John, Stefano Pasquale**
**6 Chalfont Road**
**Oxford OX2 6TH (GB)**

(56) References cited:
EP-A1- 2 535 640        WO-A1-2014/167458
CN-A- 103 123 949        CN-A- 105 098 032
CN-A- 105 140 381        CN-A- 105 609 621
CN-U- 203 367 275        CN-U- 204 289 439
US-A1- 2013 147 348

## Description

### FIELD OF THE INVENTION

The present invention relates to LED luminaries. More particularly, this invention describes an LED filament for LED light bulbs.

### BACKGROUND OF THE INVENTION

Incandescent light bulbs are a source of electric light that creates light by running electricity through a resistive filament, thereby heating the filament to a very high temperature, so that it glows and produces visible light. Incandescent bulbs are made in a wide range of sizes and voltages, from 1.5 volts to about 300 volts. The bulbs consist of a generally glass or plastic enclosure with a filament of tungsten wire inside the bulb through which an electrical current is passed. Incandescent lamps are designed as direct "plug-in" components that mate with a lampholder via a threaded Edison base connector (sometimes referred to as an "Edison base" in the context of an incandescent light bulb), a bayonet-type base connector (i.e., bayonet base in the case of an incandescent light bulb), or other standard base connector to receive standard electrical power (e.g., 120 volts A.C., 60 Hz in the United States, or 230V A.C., 50 Hz in Europe, or 12 or 24 or other D.C. voltage). The base provides electrical connections to the filament. Usually a stem or glass mount anchors to the base, allowing the electrical contacts to run through the envelope without gas or air leaks.

Incandescent light bulbs are widely used in household and commercial lighting, for portable lighting, such as table lamps, car headlamps, flashlights, and for decorative and advertising lighting. However, incandescent light bulbs are generally inefficient in terms of energy use and are subject to frequent replacement due to their limited lifetime (about 1,000 hours). Approximately 90% of the energy input is emitted as heat. These lamps are gradually being replaced by other, more efficient types of electric light such as fluorescent lamps, high-intensity discharge lamps, light emitting diodes (LEDs), etc. For the same energy input, these technologies give more visible light and generate much less heat. Particularly, LEDs consume a fraction of the energy used to illuminate incandescent bulbs and have a much longer lifetime (e.g. 50,000 to 75,000 hours). Furthermore, LED light sources are a very clean "green" light source and also provide good color reproduction.

LED light bulbs are far more efficient than traditional incandescent lamps, most notably because they use only a small fraction of the electricity of an incandescent. As traditional incandescent bulbs continue to be phased out, LED has become the mainstream light sources used on a variety of indoor and outdoor lighting fixtures. However, traditional LED light bulbs are not without its disadvantages, for example, the complicated designs which incorporate the heavy aluminum heat sinks and an electronic circuit for power conversion. Consequently, the cost is high and the shape is somewhat strange compared with the elegant the incandescent bulbs people are accustomed to.

An LED filament bulb is a light bulb that uses LEDs as its filaments. Accordingly, it is desirable to provide a novel LED filament light bulb with improved performance and aesthetics that may be used as a better replacement for a typical incandescent light bulb than traditional LED light bulbs. Desirably, light is emitted from one or more LED filaments uniformly and evenly in all directions, instead of focusing it in a specific area in the way that many traditional LED light bulbs do. Thus, the LED filament light bulb features a close resemblance with the traditional incandescent bulb. Desirably, the visually unpleasant aluminum die cast for heat dissipation in traditional LED light bulbs is no longer required in the LED filament light bulb. Thus, the LED filament light bulb is perfect for homes, hotels, restaurants, bars and places where classic style and appearance is critical. Desirably, all electronics of the LED filament light bulb is nestled inside the light bulb which is almost not visible. Desirably, light produced by the LED filament light bulb is similar to natural light. It does not have any infrared or ultraviolet radiation and it is uniform and soft on the eyes. Desirably, the LED filament light bulb fits well into all the lighting fixtures that used the outdated incandescent light bulbs. After the regulations that banned the sale of the traditional light bulbs, many homeowners could not put in compact fluorescent bulbs or other bogus LED lights into most of these old fixtures and chandeliers. Desirably, the LED filament light bulb makes it easy to reuse these old and attractive lighting fixtures. Desirably, the LED filament light bulb have remarkable energy efficiency. Desirably, the LED filament has a long service life. This extended lifespan is enhanced by a constant current source that ensures stability of parameters and prolongs the life of the light bulb. Hence, the cost of investing in these bulbs will provide cost savings for up to a few decades in some cases. Desirably, the LED filament light bulb can be placed in places where dimming of lights is necessary. The LED filament light bulb gives off a warm inviting golden soft glow when used in table lamps or as accent lights. The LED filament light bulb is perfect for creating a very pleasant atmosphere in sitting rooms or bedrooms.

There are two types of LED filament. The first one is LED filament with substrate inside and the second one is substrate-free LED filament. In the first type, LED filament with substrate inside, heat generated by the LED chips can be dissipated through the substrate thereon. CN105098032 EP 2535640, CN105140381, CN203367275U and US 2013147348 disclose examples of LED filaments with substrate inside or where the LED filaments are fixed to rigid elements. In the second type, substrate-free LED filament, there is no substrate in the LED filament. The LED chips are directly enclosed by the flexible light conversion coating. Therefore, the LED filament of the second type is more flexible than the first type LED filaments. However, heat dissipation regarding the substrate-free LED filament may be difficult. In view of these desirable features, an LED filament light bulb that is hard enough to not require a rigid substrate, avoid thermal failure and wherein the light conversion layer is not rendered so brittle to suffer structural failure if bent proposed below.

## OBJECTS AND SUMMARY OF THE INVENTION

Therefore, it is an object of the claimed invention to provide a significantly improved LED filament. The LED filament according to the invention is configured for emitting omnidirectional light, according to claim 1.

In accordance with an embodiment, surface roughness Rz of the phosphor film layer is from 1 μm to 2 mm; and surface roughness Rz of the phosphor glue layer is from 1 nm to 200 μm.

In accordance with an embodiment of the invention, the phosphor film layer is made from a first adhesive binder doped with phosphor particles; and the phosphor glue layer is made from a second adhesive binder doped with phosphor particles.

In accordance with an embodiment of the invention, the first adhesive binder is further doped with inorganic oxide nanoparticles; and the second adhesive binder is further doped with inorganic oxide nanoparticles.

In accordance with an embodiment of the invention, visible light transmittance of the transparent layer is greater than 40%; and the transparent layer is made from at least one of silica gel, silicone resin and polyimide.

## BRIEF DESCRIPTION OF FIGURES

The following detailed descriptions are illustrative examples to help the reader understand the LED according to the invention even if some of the embodiments described here below do not fall within the scope of the invention. The following detailed descriptions will be best be understood in conjunction with the accompanying figures:

FIG. 1 illustrates a perspective view of an LED light bulb with partial sectional view according to a first embodiment of the LED filament;

FIG. 2 illustrates a partial cross-sectional view at section 2-2 of FIG. 1;

FIGs. 3A and 3B illustrate disposition of the metal electrodes and the plurality of LED chips according to other embodiments of the LED filament;

FIG. 4 illustrates a perspective view of an LED filament with partial sectional view according to a second embodiment of the present disclosure;

FIG. 5 illustrates a partial cross-sectional view at section 5-5 of FIG. 4;

FIG. 6A illustrates a first embodiment of the uncut circuit film according to the second embodiment of the LED filament;

FIG. 6B illustrates the alignment between the LED chips and the first embodiment of the uncut circuit film of FIG. 6A;

FIG. 7A illustrates a second embodiment of the uncut circuit film according to the second embodiment of the LED filament;

FIG. 7B illustrates the alignment between the LED chips and the second embodiment of the uncut circuit film of FIG. 7A;

FIG. 8A illustrates a third embodiment of the uncut circuit film according to the second embodiment of the LED filament;

FIG. 8B illustrates the alignment between the LED chips and the third embodiment of the uncut circuit film of FIG. 8A;

FIGs. 9A to 9E illustrate a manufacturing method of an LED filament according to a first embodiment of the present disclosure;

FIG. 10 illustrates a manufacturing method of an LED filament according to a second embodiment of the present disclosure;

FIGs. 11A to 11E illustrate a manufacturing method of an LED filament according to a third embodiment of the present disclosure;

FIGs. 12A and 12B illustrate a perspective view of an LED light bulb according to a first and a second embodiments of the present disclosure;

FIG. 13A illustrates a perspective view of an LED light bulb according to a third embodiment of the present disclosure;

FIG. 13B illustrates an enlarged cross-sectional view of the dashed-line circle of FIG. 13A;

FIG. 14A illustrates a cross-sectional view of an LED light bulb according to a fourth embodiment of the present disclosure;

FIG. 14B illustrates the circuit board of the driving circuit of the LED light bulb according to the fourth embodiment of the present disclosure;

FIGs. 17A to 17G and FIG 22 illustrate cross-sectional views of LED filaments according to embodiments of the present disclosure wherein FIGs 17A to 17F are outside the scope of the present invention and FIG 17G is within the scope of the present invention;

## DETAILED DESCRIPTION OF THE EMBODIMENTS

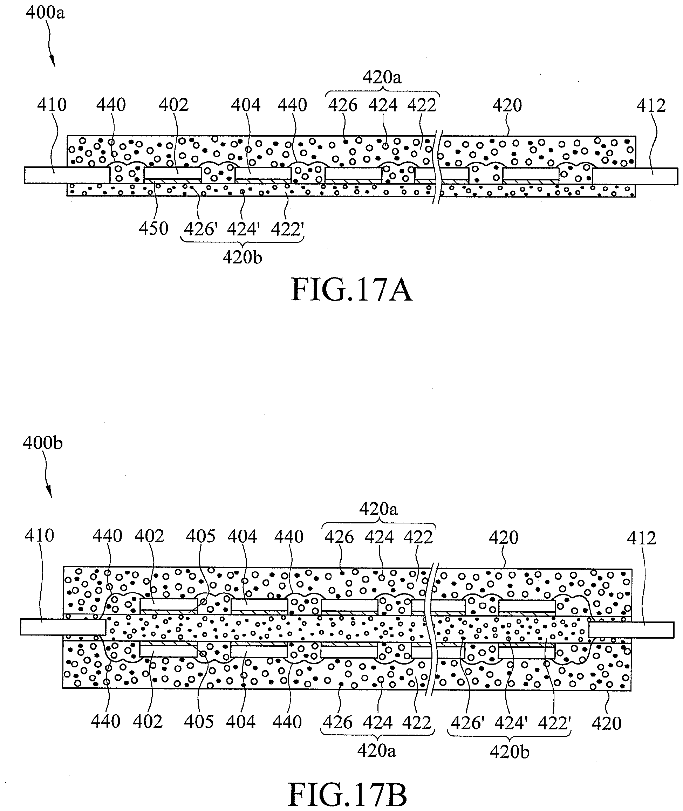

The invention will be described more fully hereinafter with reference to the accompanying drawings, in which features of the invention can be better explained. This invention is limited by definition and features present in the appended claims . Rather, the disclosed embodiments are provided so that this disclosure will be thorough and complete, and will fully convey the scope of the invention to those skilled in the art. In the drawings, the size and relative sizes of layers and regions may be exaggerated for clarity. Moreover, each embodiment described and illustrated herein includes its complementary conductivity type embodiment as well. Like numbers refer to like elements throughout, which is why the embodiments of FIGs 17A-17F are included in the description even though they are outside the scope of the claims and the invention.

It will be understood that when an element or layer is referred to as being "on," "connected to," "coupled to" or "responsive to" (and/or variants thereof) another element, it can be directly on or directly connected, coupled or responsive to the other element or intervening elements may be present. In contrast, when an element is referred to as being "directly on," "directly connected to," "directly coupled to" or "directly responsive to" (and/or variants thereof) another element, there are no intervening elements present. As used herein, the term "and/or" includes any and all combinations of one or more of the associated listed items and may be abbreviated as "/".

It will be understood that, although the terms first, second, third, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

The terminology used herein is for purposes of describing particular embodiments only and is not intended to be limiting of the invention. As used herein, the singular forms "a," "an" and "the" are intended to include the plural forms as well, unless the context clearly indicates otherwise. It will be further understood that the terms "comprises" and/or "comprising" (and/or variants thereof), when used in this specification, specify the presence of stated features, integers, steps, operations, elements, and/or components, but do not preclude the presence or addition of one or more other features, integers, steps, operations, elements, components, and/or groups thereof. In contrast, the term "consisting of" (and/or variants thereof) when used in this specification, specifies the stated number of features, integers, steps, operations, elements, and/or components, and precludes additional features, integers, steps, operations, elements, and/or components.

The present invention is described below with reference to block diagrams and/or flowchart illustrations of methods and/or apparatus (systems) according to embodiments of the invention. It is understood that a block of the block diagrams and/or flowchart illustrations, and combinations of blocks in the block diagrams and/or flowchart illustrations, can embody apparatus/systems (structure), means (function) and/or steps (methods) for implementing the functions/acts specified in the block diagrams and/or flowchart block or blocks. It should also be noted that in some alternate implementations, the functions/acts noted in the blocks may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper," depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Example embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, may be expected. Thus, the disclosed example embodiments of the invention should not be construed as limited to the particular shapes of regions illustrated herein unless expressly so defined herein, but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the invention, unless expressly so defined herein.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and the present application, and will not be interpreted in an idealized or overly formal sense unless expressly so defined herein.

The instant disclosure provides an LED filament to solve the abovementioned problems. The instant disclosure will now be described more fully hereinafter with reference to the accompanying drawings, in which exemplary embodiments of the disclosure are shown. Within the context of the present disclosure, the words "embodiment" does not mean embodiment of the invention but can also be explanatory embodiment outside the scope of the present invention yet retained in the present disclosure because it explains benefits of features also present within the invention. Within the context of the present invention, the word "disclosure" does not equate automatically to invention as the disclosure, only that it contains information relevant to features also present within the invention The invention is limited by definition and features present in the appended claims.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," or "includes" and/or "including" or "has" and/or "having" when used herein, specify the presence of stated features, regions, integers, steps, operations, elements, and/or components, but do not preclude the presence or addition of one or more other features, regions, integers, steps, operations, elements, components, and/or groups thereof.

It will be understood that the term "and/or" includes any and all combinations of one or more of the associated listed items. It will also be understood that, although the terms first, second, third etc. may be used herein to describe various elements, components, regions, parts and/or sections, these elements, components, regions, parts and/or sections should not be limited by these terms. These terms are only used to distinguish one element, component, region, part or section from another element, component, region, layer or section. Thus, a first element, component, region, part or section discussed below could be termed a second element, component, region, layer or section without departing from the teachings of the present disclosure.

The following description with reference to the accompanying drawings is provided to explain the exemplary embodiments of the disclosure. Note that in the case of no conflict, the embodiments of the present disclosure and the features of the embodiments may be arbitrarily combined with each other.

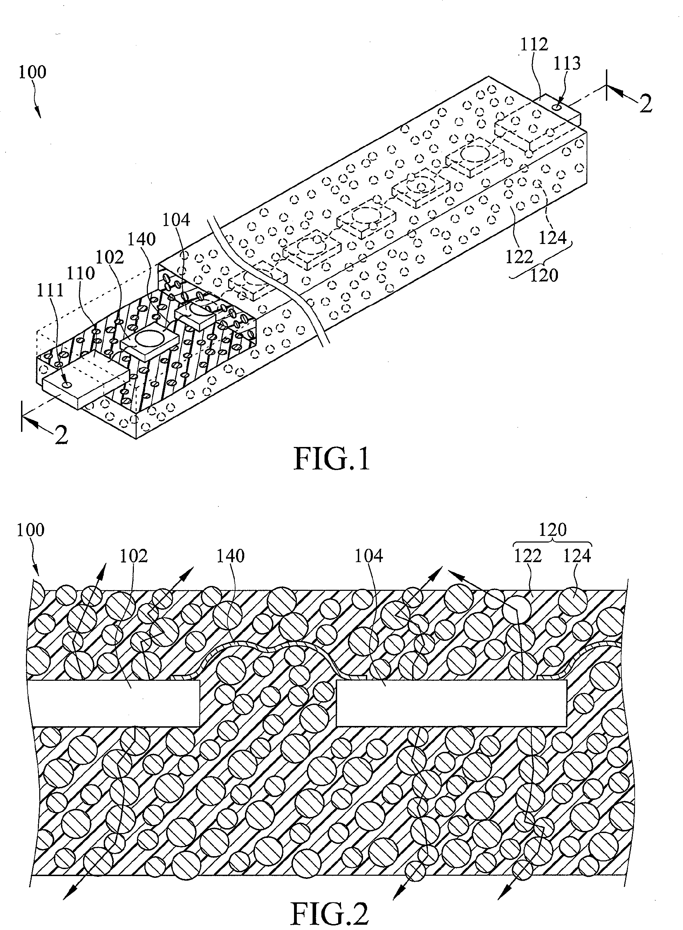

Please refer to FIGs. 1 and 2. FIG. 1 illustrates a perspective view of an LED filament with partial sectional view according to a first embodiment of the present disclosure while FIG. 2 illustrates a partial cross-sectional view at section 2-2 of FIG. 1. According to the first embodiment, the LED filament 100 comprises a plurality of LED chips 102, 104, at least two conductive electrodes 110, 112, and a light conversion coating 120. The conductive electrodes 110, 112 are disposed corresponding to the plurality of LED chips 102, 104. The LED chips 102, 104 are electrically connected together. The conductive electrodes 110, 112 are electrically connected with the plurality of LED chips 102, 104. The light conversion coating 120 coats on at least two sides of the LED chips 102, 104 and the conductive electrodes 110, 112. The light conversion coating 120 exposes a portion of two of the conductive electrodes 110, 112. The light conversion coating 120 comprises an adhesive 122 and a plurality of phosphors 124.

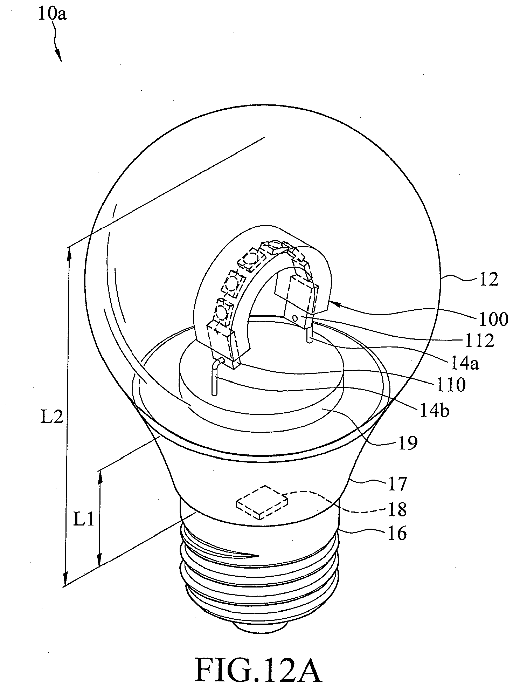

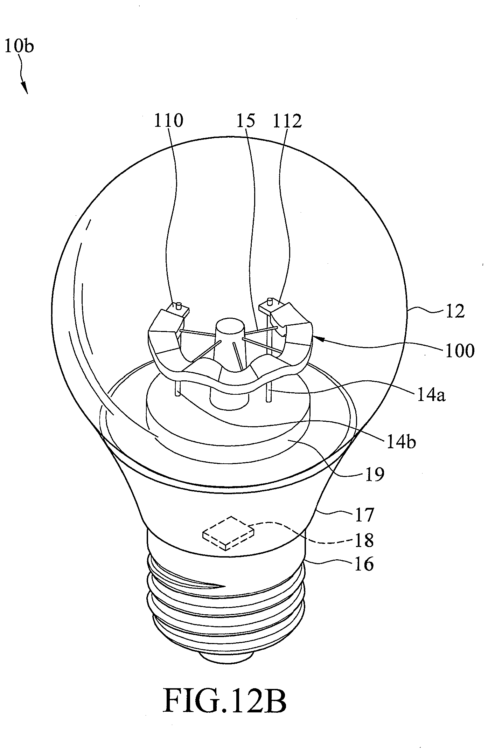

LED filament 100 emits light while the conductive electrodes 110, 112 are applied with electrical power (electrical current sources or electrical voltage sources). In this embodiment, the light emitted from the LED filament 100 is substantially close to 360 degrees light like that from a point light source. An LED light bulb 10a, 10b, illustrated is in FIGs. 12A and 12 B, utilizing the LED filament 100 is capable of emitting omnidirectional light, which will be described in detailed in the followings.

As illustrated in the FIG1, the cross-sectional outline of the LED filament 100 is rectangular. However, the cross-sectional outline of the LED filament 100 is not limited to rectangular, but may be triangle, circle, ellipse, square, diamond, or square with chamfers.

Each of LED chips 102, 104 may comprise a single LED die or a plurality of LED dies. The outline of the LED chip 102, 104 may be, but not limited to, a strip shape. The number of the LED chips 102, 104 having strip shapes of the LED filament 100 could be less, and, correspondingly the number of the electrodes of the LED chips 102, 104 is less, which can improve the illuminating efficiency since the electrodes may shield the illumination of the LED chip, thereby affecting the illumination efficiency. In addition, the LED chips 102, 104 may be coated on their surfaces with a conductive and transparent layer of Indium Tim Oxide (ITO). The metal oxide layer contributes to uniform distribution of the current diffusion and to increase of illumination efficiency. Specifically, the aspect ratio of the LED chip may be 2:1 to 10: 1; for example, but not limited to, 14 × 28 or 10 × 20. Further, the LED chips 102, 104 may be high power LED dies and are operated at low electrical current to provide sufficient illumination but less heat.

The LED chips 102, 104 may comprise sapphire substrate or transparent substrate. Consequently, the substrates of the LED chips 102, 104 do not shield/ block light emitted from the LED chips 102, 104. In other words, the LED chips 102, 104 are capable of emitting light from each side of the LED chips 102, 104.

The electrical connections among the plurality of LED chips 102, 104 and the conductive electrodes 110, 112, in this embodiment, may be shown in FIG. 1. The LED chips 102, 104 are connected in series and the conductive electrodes 110, 112 are disposed on and electrically and respectively connected with the two ends of the series-connected LED chips 102, 104. However, the connections between the LED chips 102, 104 are not limited to that in FIG. 1. Alternatively, the connections may be that two adjacent LED chips 102, 104 are connected in parallel and then the parallel-connected pairs are connected in series.

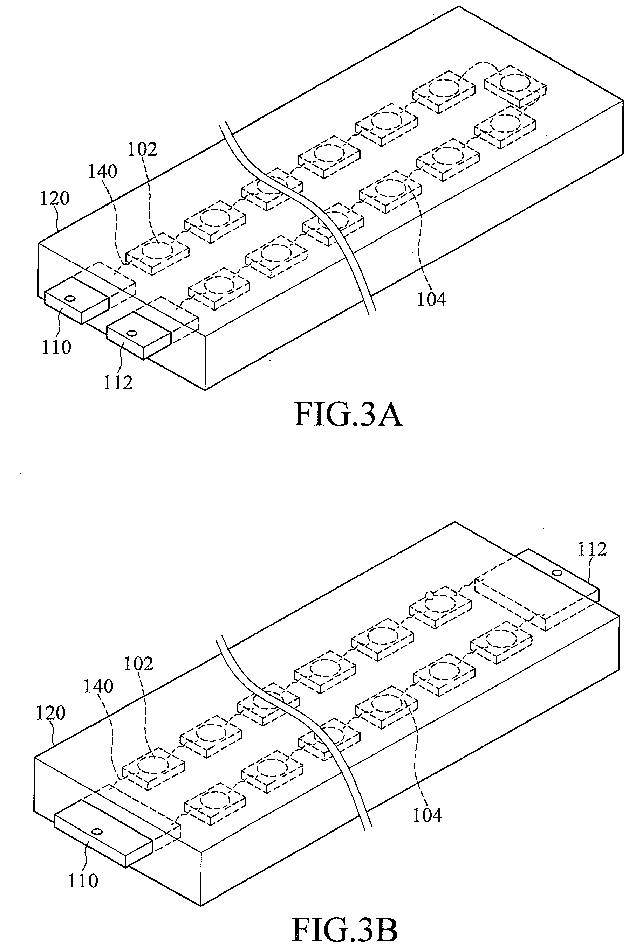

According to this embodiment, the conductive electrodes 110, 112 may be, but not limited to, metal electrodes. The conductive electrodes 110, 112 are disposed at two ends of the series-connected LED chips 102, 104 and a portion of each of the conductive electrodes 110, 112 are exposed out of the light conversion coating 120. The arrangement of the conductive electrodes 110, 112 is not limited to the aforementioned embodiment. Please refer to FIGs. 3A and 3B which illustrate disposition of metal electrodes and a plurality of LED chips according to other embodiments of the LED filament. In the embodiment of FIG. 3A, the LED chips 102, 104 are connected in series and the two ends of the series-connected LED chips 102, 104 are positioned at the same side of the LED filament 100 to form an U shape. Accordingly, the two conductive electrodes 110, 112 are positioned at the same side as the ends of the series-connected LED chips 102, 104. According to the embodiment of FIG. 3B, the LED chips 102, 104 are disposed along two parallel LED strips and the LED chips 102, 104 along the same LED strip are connected in series. Two conductive electrodes 110, 112 are disposed at two ends of the two parallel and series-connected LED chips 102, 104 and electrically connected to each of ends of the series-connected LED chips 102, 104. In this embodiment of FIG. 3B, there are, but not limited to, only two conductive electrodes 110, 112. For examples, the LED filament 100, in practices, may comprise four sub-electrodes. The four sub-electrodes are connected to four ends of the series-connected LED chips 102, 104, respectively. The sub-electrodes may be connected to anode and ground as desired. Alternatively, one of two conductive electrodes 110, 112 may be replaced with two sub-electrodes, depending upon the design needs.

Please further refer to FIG. 12A. The conductive electrodes 110, 112 has through holes 111, 113 (shown in FIG. 1) on the exposed portion for being connected with the conductive supports 14a, 14b of the LED light bulb 10a.

Please refer to FIGs. 1 and 2 again. According to this embodiment, the LED filament 100 further comprises conductive wires 140 for electrically connecting the adjacent LED chips 102, 104 and conductive electrodes 110, 112. The conductive wires 140 may be gold wires formed by a wire bond of the LED package process, like Q-type. According to FIG. 2, the conductive wires 140 are of M shape. The M shape here is not to describe that the shape of the conductive wires 140 exactly looks like letter M, but to describe a shape which prevents the wires from being tight and provides buffers when the conductive wires 140 or the LED filament 100 is stretched or bended. Specifically, the M shape may be any shape formed by a conductive wire 140 whose length is longer than the length of a wire which naturally arched between two adjacent LED chips 102, 104. The M shape includes any shape which could provide buffers while the conductive wires 104 are bended or stretched; for example, S shape.

The light conversion coating 120 comprises adhesive 122 and phosphors 124. The light conversion coating 120 may, in this embodiment, wrap or encapsulate the LED chips 102, 104 and the conductive electrodes 110, 112. In other words, in this embodiment, each of six sides of the LED chips 102, 104 is coated with the light conversion coating 120; preferably, but not limited to, is in direct contact with the light conversion coating 120. However, at least two sides of the LED chips 102, 104 may be coated with the light conversion coating 120. Preferably, the light conversion coating 120 may directly contact at least two sides of the LED chips 102, 104. The two directly-contacted sides may be the major surfaces which the LED chips emit light. Referring to FIG. 1, the major two surfaces may be the top and the bottom surfaces. In other words, the light conversion coating 120 may directly contact the top and the bottom surfaces of the LED chips 102, 104 (upper and lower surfaces of the LED chips 102, 104 shown in FIG. 2). Said contact between each of six sides of the LED chips 102, 104 and the light conversion coating 120 may be that the light conversion coating 120 directly or indirectly contacts at least a portion of each side of the LED chips 102, 104. Specifically, one or two sides of the LED chips 102, 104 may be in contact with the light conversion coating 120 through die bond glue. In some embodiments, the die bond glue may be mixed with phosphors to increase efficiency of light conversion. The die bond glue may be silica gel or silicone resin mixed with silver powder or heat dissipating powder to increase effect of heat dissipation thereof. The adhesive 122 may be silica gel. In addition, the silica gel may be partially or totally replaced with polyimide or resin materials (e.g., silicone resin) to improve the toughness of the light conversion coating 120 and to reduce possibility of cracking or embrittlement.

The phosphors 124 of the light conversion coating 120 absorb some form of radiation to emit light. For instance, the phosphors 124 absorb light with shorter wavelength and then emit light with longer wavelength. In one embodiment, the phosphors 124 absorb blue light and then emit yellow light. The blue light which is not absorbed by the phosphors 124 mixes with the yellow light to form white light. According to the embodiment where six sides of the LED chips 102, 104 are coated with the light conversion coating 120, the phosphors 124 absorb light with shorter wavelength out of each of the sides of the LED chips 102, 104 and emit light with longer wavelength. The mixed light (longer and shorter wavelength) is emitted from the outer surface of the light conversion coating 120 which surrounds the LED chips 102, 104 to form the main body of the LED filament 100. In other words, each of sides of the LED filament 100 emits the mixed light.

The light conversion coating 120 may expose a portion of two of the conductive electrodes 110, 112. Phosphors 124 is harder than the adhesive 122. The size of the phosphors 124 may be 1 to 30 um (micrometer) or 5 to 20 um. The size of the same phosphors 124 are generally the same. In FIG. 2, the reason why the cross-sectional sizes of the phosphors 124 are different is the positions of the cross-section for the phosphors 124 are different. The adhesive 122 may be transparent, for example, epoxy resin, modified resin or silica gel, and so on.

The composition ratio of the phosphors 124 to the adhesive 122 may be 1:1 to 99:1, or 1:1 to 50:1. The composition ratio may be volume ratio or weight ratio. Please refer to FIG. 2 again. The amount of the phosphors 124 is greater than the adhesive 122 to increase the density of the phosphors 124 and to increase direct contacts among phosphors 124. The arrow lines on FIG. 2 show thermal conduction paths from LED chips 102, 104 to the outer surfaces of the LED filament 100. The thermal conduction paths are formed by the adjacent and contacted phosphors. The more direct contacts among the phosphors 124, the more thermal conduction paths forms, the greater the heat dissipating effect the LED filament 100 has, and the less the light conversion coating becomes yellow. Additionally, the light conversion rate of the phosphors 124 may reach 30% to 70% and the total luminance efficiency of the LED light bulb 10a, 10b is increased. Further, the hardness of the LED filament 100 is increased, too. Accordingly, the LED filament 100 may stand alone without any embedded supporting component like rigid substrates. Furthermore, the surfaces of cured LED filament 100 are not flat due to the protrusion of some of the phosphors 124. In other words, the roughness of the surfaces and the total surface area are increased. The increased roughness of the surfaces improves the amount of light passing the surfaces. The increased surface area enhances the heat dissipating effect. As a result, the overall luminance efficiency of the LED light filament 100 is raised.

Next, LED chips 102, 104 may comprise LED dies which emit blue light. The phosphors 124 may be yellow phosphors (for example Garnet series phosphors, YAG phosphors), so that the LED filament 100 may emit white light. In practices, the composition ratio of phosphors 124 to the adhesive 122 may be adjusted to make the spectrum of the white light emitted from the LED filament 100 closer to that emitted from incandescent bulbs. Alternatively, the phosphors 124 may be powders which absorb blue light (light with shorter wavelength) and emit yellow green light (hereinafter referred to yellow green powders) or emit red light (hereinafter referred to red powders) (light with longer wavelength). The light conversion coating 120 may comprise less red powders and more yellow green powders, so that the CCT (corrected color temperature) of the light emitted from the LED filament 100 may close to 2,400 to 2,600 K (incandescent light).

As mention above, a desired deflection of the LED filament 100 may be achieved by the adjustment of the ratio of phosphors 124 to the adhesive 122. For instance, the Young's Modulus (Y) of the LED filament 100 may be between $0.1 \times 10^{10}$ to $0.3 \times 10^{10}$ Pa. If necessary, the Young's Modulus of the LED filament 100 may be between $0.15 \times 10^{10}$ to $0.25 \times 10^{10}$ Pa. Consequently, the LED filament 100 would not be easily broken and still possess adequate rigidity and deflection.

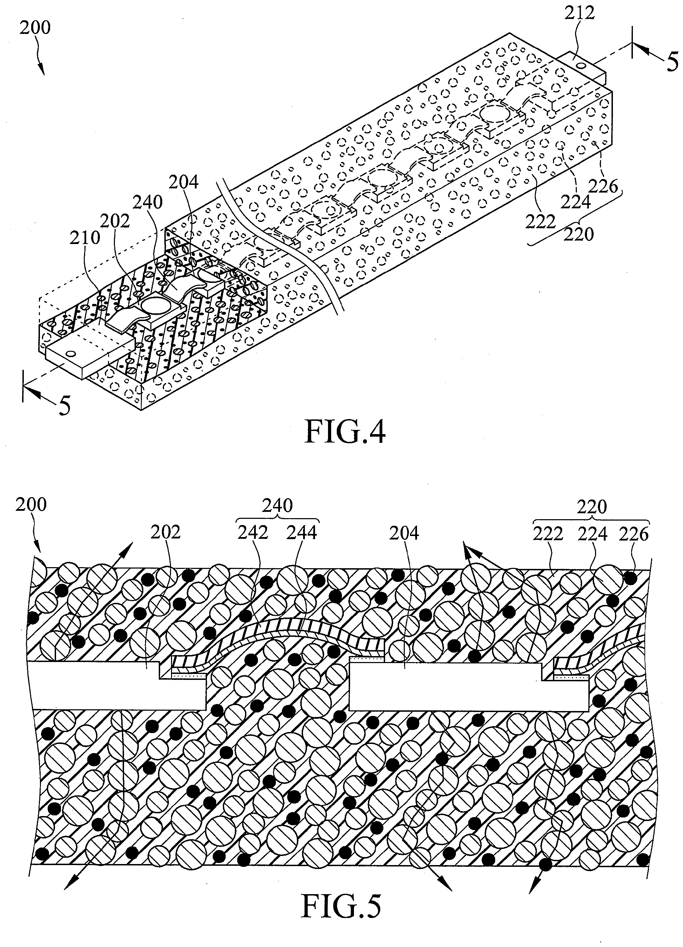

Please refer to FIGs. 4 to 5. FIG. 4 illustrates a perspective view of an LED light bulb with partial sectional view according to a second embodiment of the LED filament and FIG. 5 illustrates a partial cross-sectional view at section 5-5 of FIG. 4.

According to the second embodiment of the LED filament 200, the LED filament 200 comprises a plurality of LED chips 202, 204, at least two conductive electrodes 210, 212, and a light conversion coating 220. The conductive electrodes 210, 212 are disposed corresponding to the plurality of LED chips 202, 204. The plurality of LED chips 202, 204 and the conductive electrodes 212, 214 are electrically connected therebetween. The light conversion coating 220 coats on at least two sides of the LED chips 202, 204 and the conductive electrodes 210, 212. The light conversion coating 220 exposes a portion of two of the conductive electrodes 210, 212. The light conversion coating 220 comprises an adhesive 222, a plurality of inorganic oxide nanoparticles 226 and a plurality of phosphors 224.

The size of the plurality of inorganic oxide nanoparticles 226 is around 10 to 300 nanometers (nm) or majorly is around 20 to 100 nm. The size of the plurality of inorganic oxide nanoparticles 226 is lesser than that of the phosphors 224. The plurality of the inorganic oxide nanoparticles 226 may be, but not limited to, aluminium oxides (Al2O3), silicon oxide (SiO2), zirconium oxide (Zirconia, ZrO2), titanic oxide (TiO2), Calcium oxide (CaO), strontium oxide (SrO), and Barium oxide (BaO).

As shown in FIG. 5, the inorganic oxide nanoparticles 226 and the phosphors 224 are mixed with the adhesive 222. The unit prices and the hardnesses of the inorganic oxide nanoparticles 226 and the phosphors 224 are different. Therefore, a desired deflection, thermal conductivity, hardness, and cost of the LED filament 200 may be reached by adjustment of the ratio of the adhesive 222, phosphors 224 to the inorganic oxide nanoparticles 226 affects. In addition, due that the size of the inorganic oxide nanoparticles 226 is lesser than that of the phosphors 224, the inorganic oxide nanoparticles 226 may fill into the gaps among the phosphors 224. Hence, the contact area among the phosphors 224 and the inorganic oxide nanoparticles 226 is increased and thermal conduction paths are increased as shown by arrow lines on FIG. 5, too. Further, the inorganic oxide nanoparticles 226 may deflect or scatter light incident thereon. The light deflection and scattering make the light emitted from phosphors 224 mixed more uniformly and the characteristics of the LED filament 200 becomes even better. Furthermore, the impedance of the inorganic oxide nanoparticles 226 is high and no electrical leakage would happen through the inorganic oxide nanoparticles 226.

In some embodiments, the phosphors 224 are substantially uniformly distributed in the adhesive 222 (for instance, in silica gel, the polyimide or resin materials). Each of the phosphors 224 may be partially or totally wrapped by the adhesive 222 to improve the cracking or embrittlement of the light conversion coating 220. In the case that not each of the phosphors 224 is totally wrapped by the adhesive 222, the cracking or embrittlement of the light conversion coating 220 is still improved. In some embodiments, silica gel may be mixed with the polyimide or resin materials to form the light conversion coating 220.

The LED filament 200 further comprises a plurality of circuit film 240 (or call as transparent circuit film) for electrically and correspondingly connected among the plurality of LED chips and the conductive electrodes. Specifically, the plurality of circuit film 240 is electrically connecting the adjacent LED chips 202, 204 and conductive electrodes 210, 212. The light conversion coating 220 may encapsulate the plurality of circuit film 240.

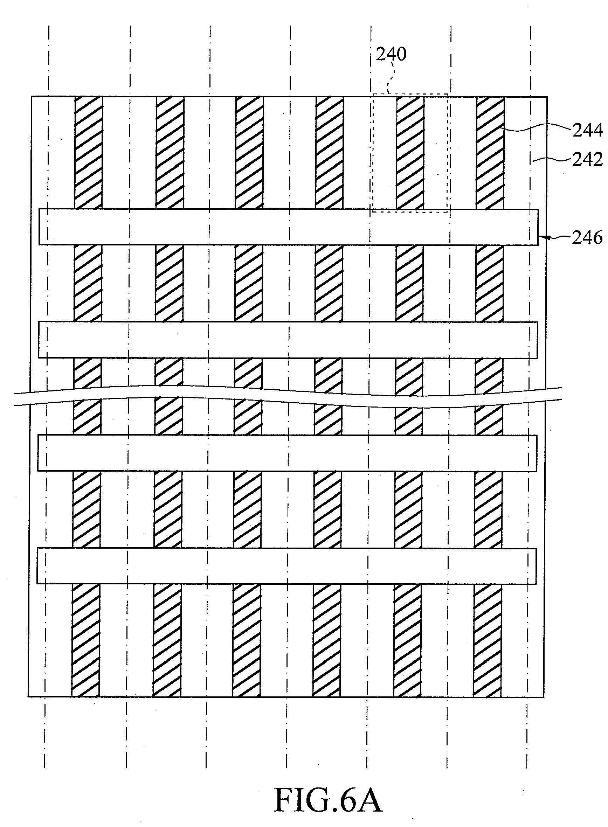

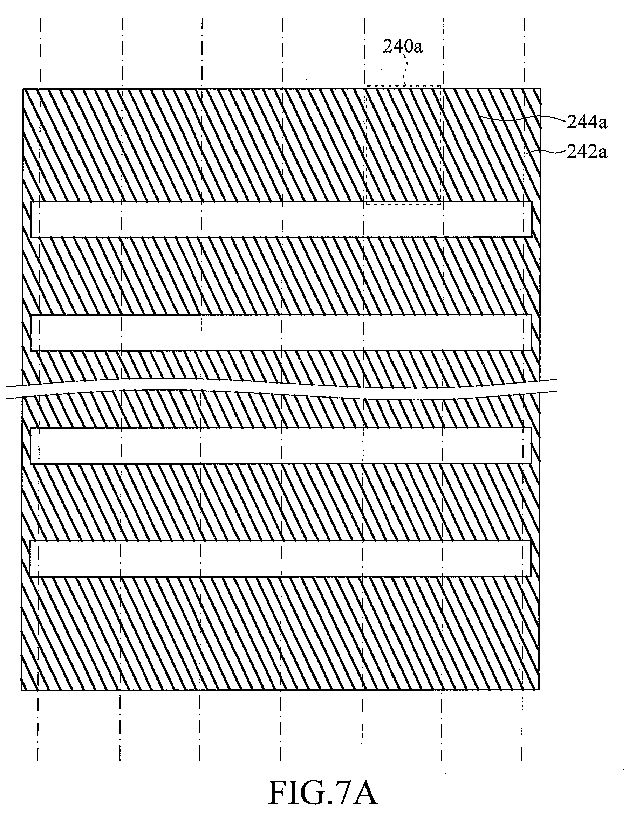

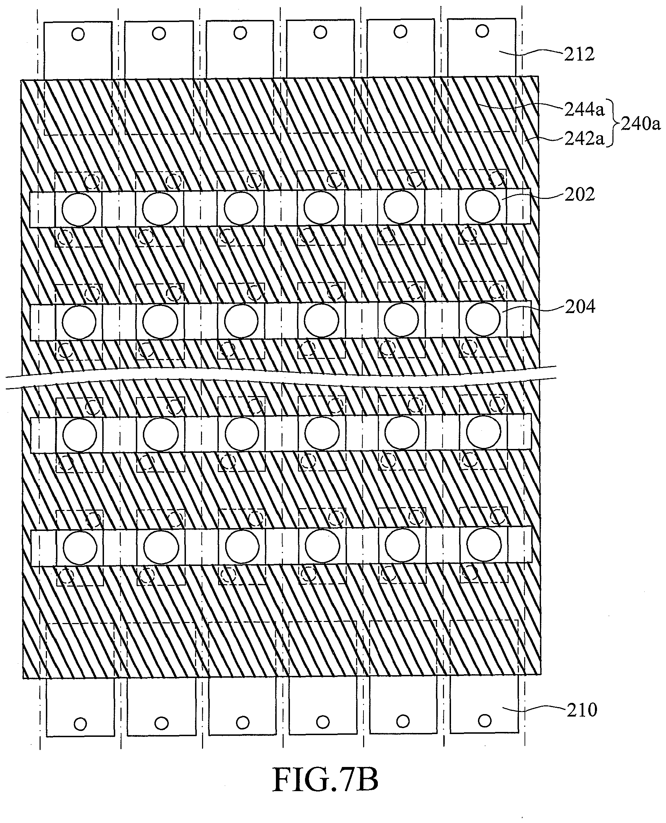

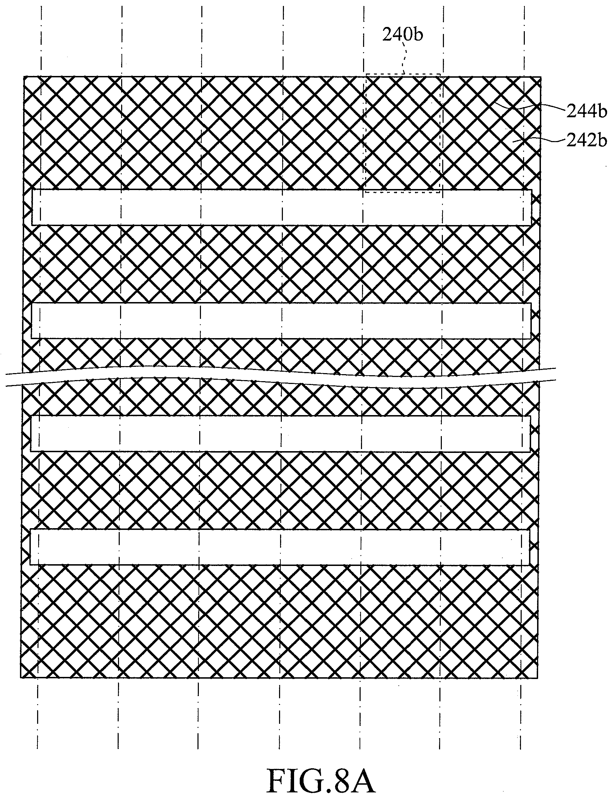

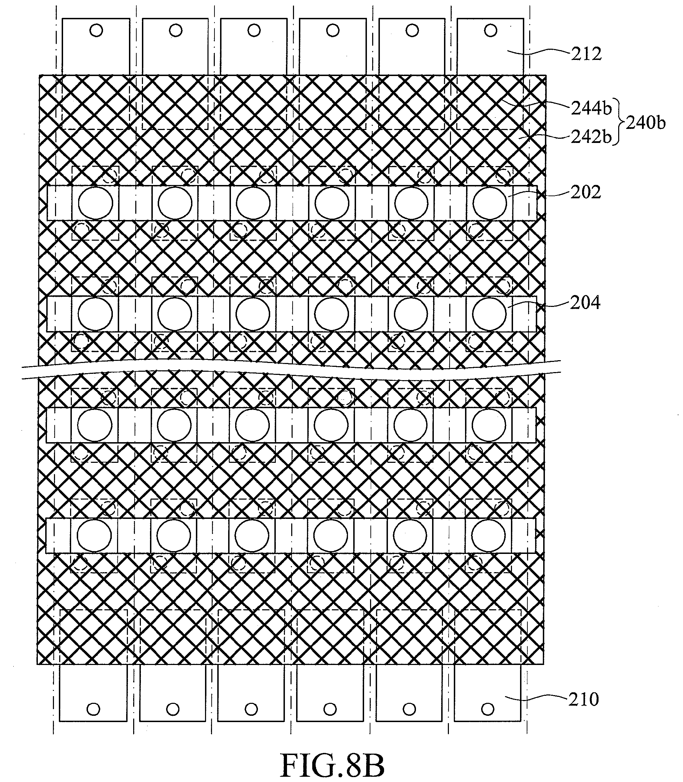

Please refer to FIGs. 6A. FIG. 6A illustrates a first embodiment of the uncut circuit film according to the second embodiment of the LED filament 200. Each of the circuit films 240 comprises a first film 242 and a conductive circuit 244 disposed on the first film 242. The first film 242 in one embodiment may be, but not limited to, a thin film. In order to be easily understood the embodiments, the following description uses thin film as an example for the first film 242. However, the thin film 242 is not the only embodiment for the first film 242. The thin film 242 may be a transparent or translucent film. The transparent film may allow light emitted from the LED chips 202, 204 and/ or phosphors 124 to pass. The conductive circuits 244 are electrically and correspondingly connected among the plurality of LED chips 202, 204 and the conductive electrodes 210, 212. In this embodiment, the conductive circuits 244 are of bar shape and substantially parallel to each other. However, the conductive circuits 244 may be in other shape or pattern. Please refer to FIG. 7A which illustrates a second embodiment of the uncut circuit film according to the second embodiment of the LED filament. Each of the circuit films 240a comprises a thin film 242a and a conductive circuit 244a disposed on the thin film 242a. The conductive circuits 244a are substantially parallel lines electrically connected with pads of adjacent LED chips 202, 204 as shown in FIG. 7B. Please refer to FIG. 8A which illustrates a third embodiment of the uncut circuit film according to the second embodiment of the LED filament. Each of the circuit films 240b comprises a thin film 242b and a conductive circuit 244b disposed on the thin film 242b. The conductive circuits 244b are crossover lines electrically connected with pads of adjacent LED chips 202b, 204b as shown in FIG. 8B. The width of the lines may be 10 micrometers (um) and the thickness of the lines may be 2 um. The pattern or shape of the conductive circuits 244, 244a, 244b are not limited to the above-mentioned embodiments, any pattern or shape which is capable of connecting pads of adjacent LED chips 202, 204 and conductive electrodes 210, 212 are feasible.

The thin film 242 may be, but not limited to, Polyimide film (PI film). Transmittance of the polyimide film is above 92%. The material of the conductive circuit 244 may be, but not limited to, indium tin oxide (ITO), nano-silver plasma, metal grids, or nano-tubes. The advantages of Silver include good reflection and low light absorption. Nanoscaled silver lines in grid shape have advantages of low resistance and high penetration of light. In addition, gold-doped nano-silver lines may enhance the adherence between the pads of the LED chips 202, 204 and the sliver lines (conductive circuits).

Please refer to FIG. 6A again. The circuit film 240 may be made by firstly forming conductive circuits 244 on a thin film 242, and then forming slots 246 on the thin film 242 with the conductive circuits 244.

Please refer to FIG. 6A. The conductive circuits 244 do not cover the whole surface of the thin film 242. Consequently, light emitted from the LED chips 202, 204 can pass through the circuit film 240 at least from the portion of the thin film 242 where the conductive circuits 244 do not occupy. In the second embodiment, the circuit film 240 is used to electrically connect with adjacent LED chips 202, 204 and the conductive electrodes 210, 212. The circuit film 240 has the advantages of wider conductive lines, better deflection, and better toughness (less possibility of being broken) than the conductive wires 140 in the first embodiments.

Regarding the electrical connection among the circuit film 240, LED chips 202, 204, and the conductive electrodes 210, 212, conductive glues may be applied on the surfaces of the LED chips 202, 204 and the conductive electrodes 210, 212 where the conductive circuits 244 are going to electrically connect. The conductive glues may be, but not limited to, silver paste, solder paste (tin paste), or conductive glues doped with conductive particles. Then, dispose the circuit film 240 on the LED chips 202, 204 and the conductive electrodes 210, 212 with adequate alignment and cure the circuit film 240 and the conductive glues by heat or UV.

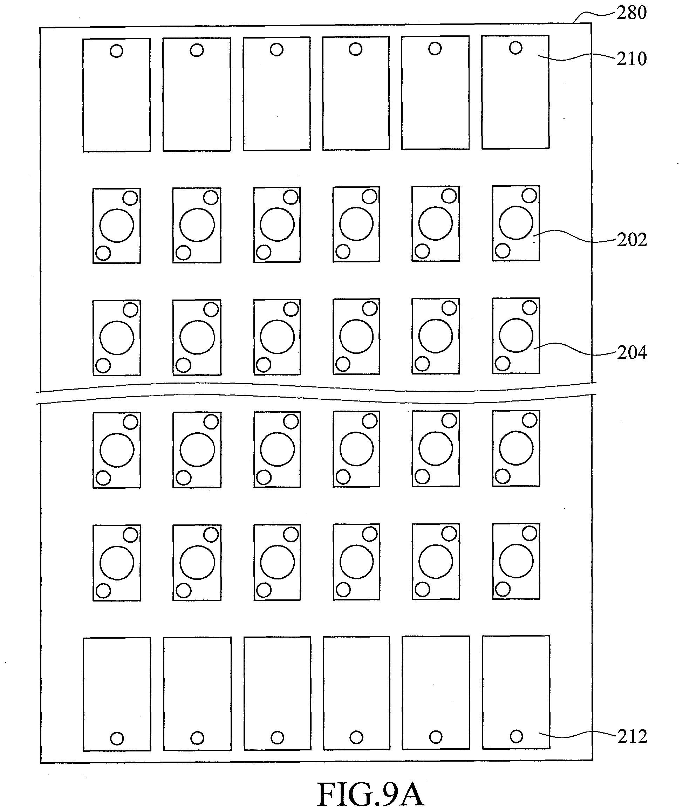

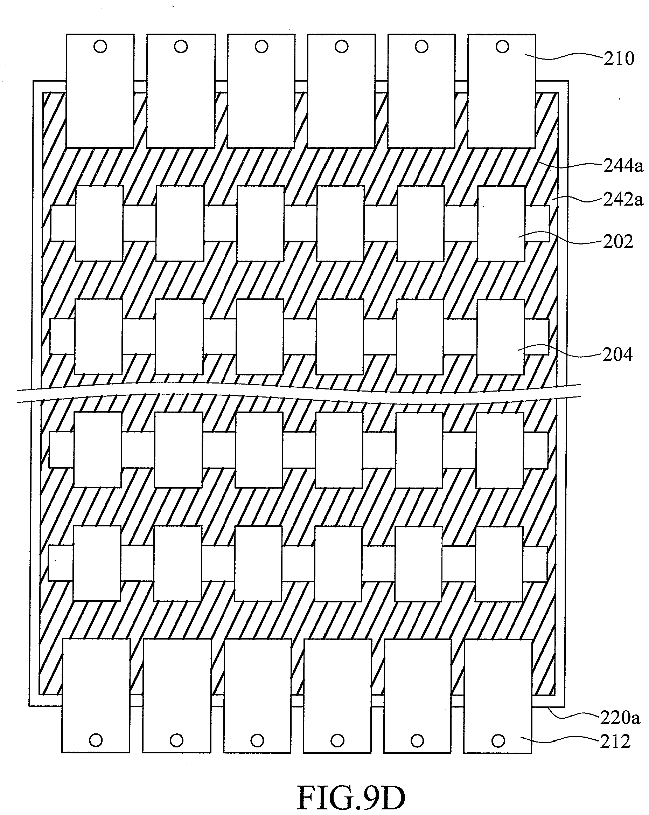

Please refer to FIGs. 9A to 9E which illustrate a manufacturing method of an LED filament according to a first embodiment. The manufacturing method of the LED filament 200 comprises:

S20: dispose LED chips 202, 204 and at least two conductive electrodes 210, 210 on a carrier 280, referring to FIG. 9A;

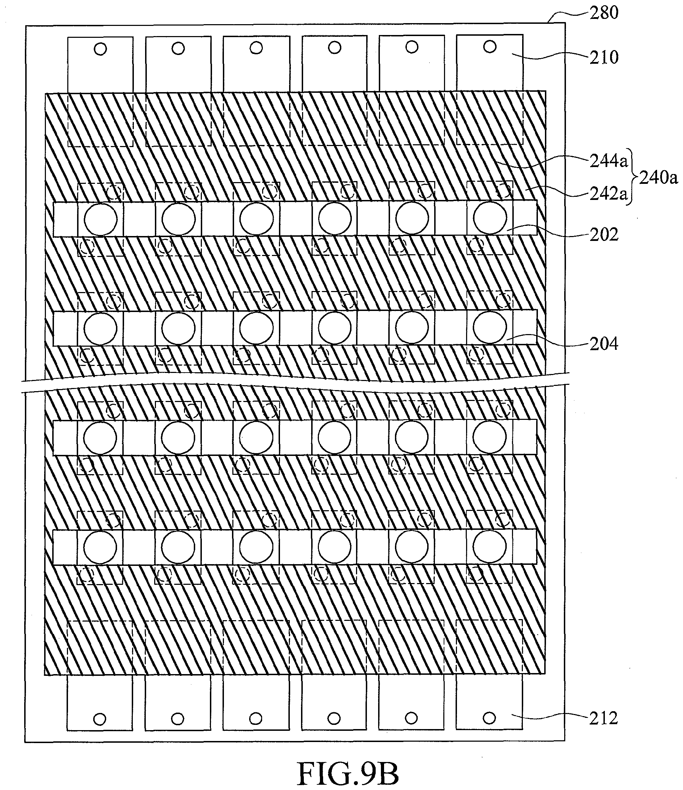

S22: electrically connect the LED chips 202, 204 with the conductive electrodes 210, 212, referring to FIG. 9B; and

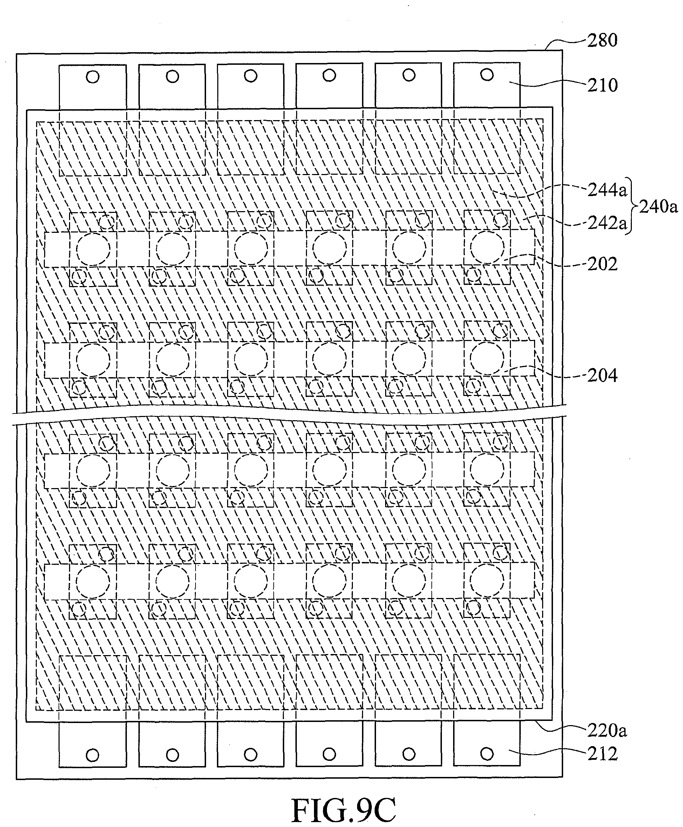

S24: dispose a light conversion coating 220 on the LED chips 202, 204 and the conductive electrodes 210, 212. The light conversion coating 220 coats on at least two sides of the LED chips 202, 204 and the conductive electrodes 210, 212. The light conversion coating 220 exposes a portion of at least two of the conductive electrodes 210, 212. The light conversion coating 220 comprises adhesive 222 and a plurality of phosphors 224, referring to FIG. 9C to 9E.

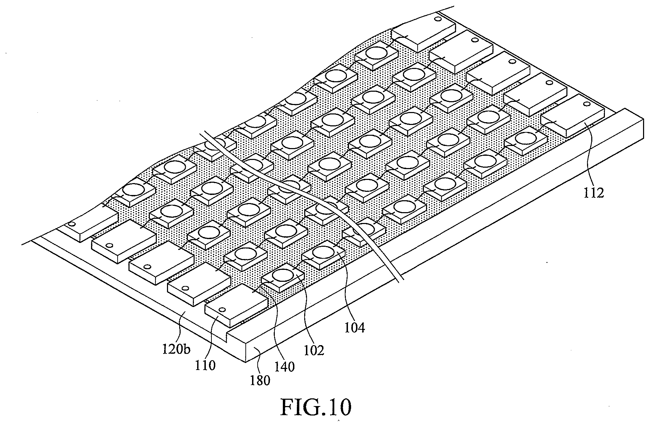

In S20, the plurality of LED chips 202, 204 are disposed in a rectangular array. Each column of the LED chips 202, 204, at the end of the manufacturing process, may be cut into a single LED filament 200. During disposition of the LED chips 202, 204, the anodes and cathodes of the LED chips 202, 204 should be properly orientated for later connected in series or parallel. The carrier 280 may be, but not limited to, glass substrate or metal substrate. The carrier 280 may be, but not limited to, a plate like that shown in FIG. 9A, or a plate with a groove like the carrier 180 shown in FIG. 10. The groove is for being disposed with the base layer 120b.

In S22, the uncut circuit film 240a is similar to the circuit film 240a shown in FIG. 7A. The LED chips 202, 204 and the conductive circuit 210, 212 are electrically connected by the parallel conductive lines. Alternatively, the circuit film 240, 240b shown, respectively, in FIG. 6A or 8A may be used in S22. The conductive wires 140 shown in FIG. 2 can be used in S22, too.

In S24, the light conversion coating 220 may be coated on the LED chips 202, 204 and the conductive electrodes 210, 212 by different method. Firstly, taking FIG. 9C to 9E as an example, the manufacturing method of S24 comprises:

S240: coat a light conversion sub-layer (top layer 220a) on a surface of the LED chips 202, 204 and the conductive electrodes 210, 212 which is not contact with the carrier 280;

S242: flip over the LED chips 202, 204 and the conductive electrodes 210, 212 disposed with the top layer 220a; and

S244: coat a light conversion sub-layer (base layer 220b) on a surface of the LED chips 202, 204 and the conductive electrodes 210, 212 which are not coated with the top layer 220a.

In order to distinguish the light conversion sub-layers in S240 and in S244, the light conversion sub-layer in S240 is referred to top layer 220a and the light conversion sub-layer in S244 is referred to base layer 220b hereinafter.

In S240, after the LED chips 202, 204 and the conductive electrodes 210, 212 are coated with the top layer 220a, the adhesive 222 and the phosphors 224 will fill out the gaps among the LED chips 202, 204 and the conductive electrodes 210, 212. Then, proceed with a curing process to harden the top layer which encapsulates the upper part of the LED chips 202, 204 and the conductive electrodes 210, 212 and exposes a portion of at least two of the conductive electrodes 210, 212. The curing process may be done by heat or UV.

In S242, the flip-over of the semi-finished piece may be done by two different ways in accordance with different situations. Concerning the first flip-over way, the LED chips 202, 204 and the conductive electrodes 210, 212 are disposed on the carrier 280 without any adherences with the carrier 280. S242 can be done by flip the cured semi-finished piece over directly. Then, place the flipped-over semi-finished piece on the carrier 280 again. (The semi-finished piece is the cured the LED chips 202, 204 and the conductive electrodes 210, 212 covered with the top layer 220a.)

As for the second way, glues are applied on the carrier 280. The glues are, for instance, photoresist in semiconductor process, or die bond glues. The glues (photoresist or die bond glues) is for temporarily fixing the LED chips 202, 204 and the conductive electrodes 210, 212 on the carrier 280. The glue may be removed by acetone or solvent and the semi-finished piece is separated from the carrier 280. If necessary, the remained glues may be removed by an additional cleaning process.

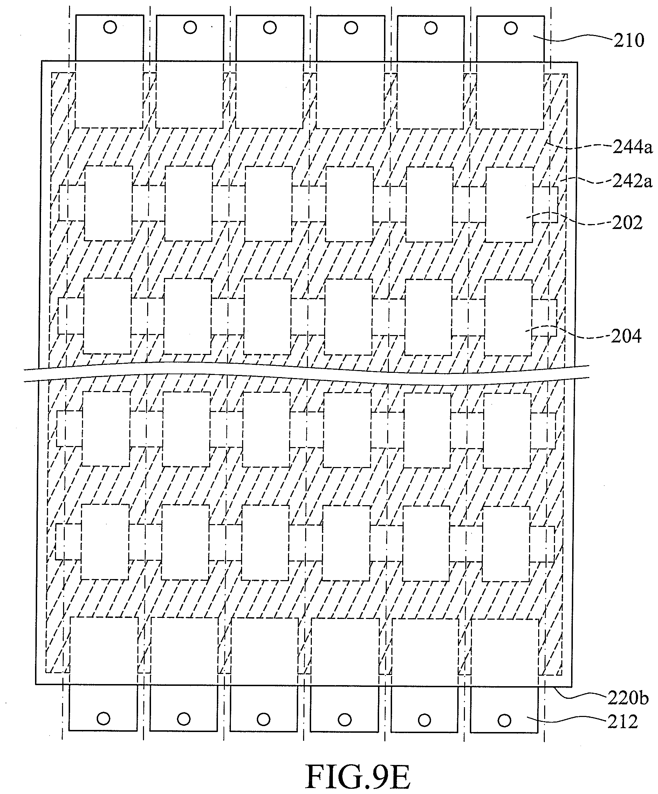

In S244, referring to FIG. 9E, cure the base layer 220b after the base layer 220b is coated on the surface of the LED chips 202, 204 and the conductive electrodes 210, 212.

Referring to FIG. 9C, the top layer 220a is slightly greater than the uncut circuit film 240a. However, it is not a requirement. The sizes of the top layer 220a may be the same as or lesser than that of the uncut circuit film 240a. Referring to FIG. 9E, the area of the top layer 220a is substantially the same as that of the base layer 220b. It is not a requirement, either. In implementation, the area of the top layer 220a may be greater or lesser than the area of the base layer 220b. FIG. 9E illustrates a semi-finished LED filament where a plurality of LED filaments 200 are integrated into one piece.

After S24, the method may further comprise S26: cut the semi-finished LED filament along the dot-and-dash lines shown in FIG. 9E. Each cut portion is an LED filament 200. The semi-finished LED may be cut every other two dot-and-dash lines.

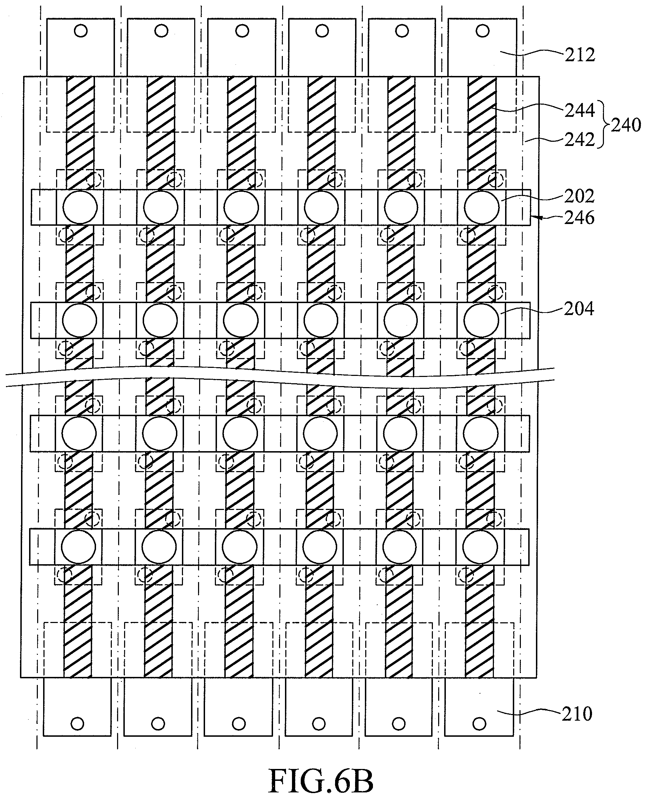

FIGs. 6B, 7B and 8B illustrate uncut circuit films 240, 240a, 240b of FIGs. 6A, 7A and 8A covering the LED chips 202, 204 and the conductive electrodes 210, 212 with proper alignment.

The method of FIGs. 9A to 9E illustrates each LED filament are disposed in a rectangular array manner. Alternatively, the disposition of S20 may be a single column of LED chips 202, 204. In the consequence, S26 may be omitted.

Please refer to FIG. 10 for the second embodiment of the manufacturing method for the LED filament 200. The method comprises:

    S20A: coat a light conversion sub-layer (a base layer 120b) on a carrier 180;

    S20B: dispose LED chips 102, 104 and conductive electrodes 110, 112 on the base layer 120b;

    S22: electrically connect the LED chips 102, 104 with the conductive electrodes 110, 112; and

    S24: coat a light conversion sub-layer (top layer 120a) on the LED chips 102, 104 and the conductive electrodes 110, 112. The top layer 120a coats on the LED chips 102, 104 and the conductive electrodes 110, 112. The top layer 120a and the base layer 120b expose a portion of at least two of the conductive electrodes 110, 112. The light conversion coating 120 (top layer 120a and the base layer 120b) comprises adhesive 122 and a plurality of phosphors 124.

As shown in FIG. 10, the base layer 120b is a part of the light conversion coating 120 and comprises an adhesive 122 and phosphors 124. In the embodiment of FIG. 10, the base layer 120b is, but not limited to, coated on the carrier 180 with a groove. Alternatively, the carrier 180 can be omitted. In other words, the base layer 120b may be place on a work table without any carrier 180. The LED chips 102, 104 and the conductive electrodes 110, 112 are disposed on the base layer 120b.

The thickness of the base layer 120b may be 50 to 100 um. The composition ratio of phosphors 124 to the adhesive 122 can be adjusted and the thickness of the base layer 120b may be around 60 to 80 um. After S20, a pre-curing process may be used to slightly cure the base layer 120b so that the LED chips 102, 104 and the conductive electrodes 110, 112 can be fixed on the base layer 120b. Besides, the LED chips 102, 104 and the conductive electrodes 110, 112 may be fixed on the base layer 120b by die bond glues.

After the electrical connection of S22, the top layer 120a is coated on the LED chips 102, 104 and the conductive electrodes 110, 112 and then a curing process is proceeded with to cure the top layer 120a. Consequently, the flip-over of S242 and glueremoving process are omitted.

According to the embodiment of FIG. 10, after S24, the process of S26 may be proceeded with.

The base layer 120b is used for carrying the LED chips 102, 104 and the conductive electrodes 110, 112 and its thickness may be 0.5 to 3 millimeters (mm) or 1 to 2 mm.

The composition ratio of phosphors 124 to the adhesive 122 may be adjusted accordingly to make the base layer 120b hard enough to sufficiently carry the LED chips 102, 104 and the conductive electrodes 110, 112 and for the following process like wire bond. The Shore D Hardness of the base layer 120b may be at least 60 HD. Hence, the overall LED filament 100a will have enough hardness, rigidity and deflection. The electrical conductivity of the connection among the LED chips 102, 104 and the conductive electrodes 110, 112 can be maintained even though the LED filament 100a is bent.

In accordance with the embodiment of FIG. 10, the hardness of the cured base layer 120b is better to be sufficient to carry the LED chips 102, 104 and the conductive electrodes 110, 112 and to support for the wire bonding process. However, the top layer 120a is not required to have the same hardness as the base layer 120b. Accordingly, the adjustment of ratio of the phosphors 124 to the adhesive 122 is more flexible. Alternatively, the light conversion coating 120 may comprise inorganic oxide nanoparticles 224 (not shown in FIG. 10).

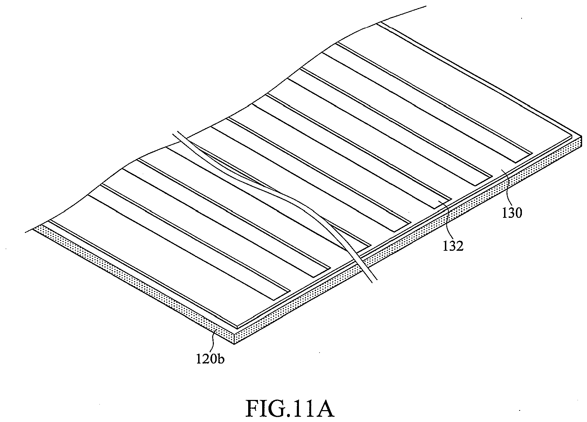

Next, please refer to FIGs. 11A to 11E which illustrate a manufacturing method of an LED filament according to a third embodiment. The manufacturing method for an Led filament 100a comprises:

    S202: dispose conductive foil 130 on a light conversion sub-layer (base layer 120b), referring to FIG. 11A;

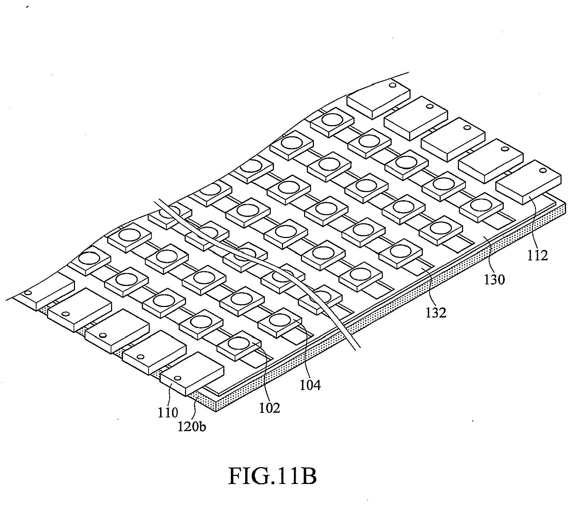

    S204: dispose a plurality of LED chips 102, 104 and a plurality of conductive electrodes 110,112 on the conductive foil 130, referring to FIG. 11B;

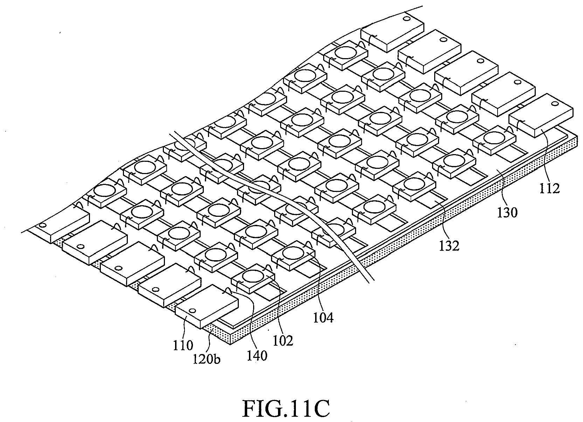

    S22: electrically connect the LED chips 102, 104 with the conductive electrodes 110, 112, referring to FIG. 11C; and

    S24: coat a light conversion sub-layer (top layer 120a) on the surfaces of the LED chips 102, 104 and the conductive electrode 110, 112 where may be not in contact with the conductive foil 130. The light conversion coating 120 (including the base layer 120b and the top layer 120a) coats on at least two sides of the LED chips 102, 104 and the conductive electrodes 110, 112. The light conversion coating 120 exposes a portion of at least two of the plurality of conductive electrodes 110, 112. The light conversion coating 120 comprises adhesive 122 and phosphors 124.

Please refer to FIG. 11A, the light conversion coating of S202 is called as the base layer 120b. The conductive foil 130 may have a plurality of openings 132. The width of each of the openings 132 may be lesser than the length of the LED chips 102, 104 and each of the openings 132 is aligned with the portion of the LED chips 102, 104 which emits light. Therefore, light emitted from LED may pass through the openings 132 without any shielding or blocking.

The conductive foil 130 may be, but not limited to, a copper foil coated with silver. The openings 132 may be formed by punching or stamping on a copper foil.

Before S202, the method may comprise a pre-step: dispose the base layer 120b on a carrier (like 180 of FIG. 10) or on a work table.

In S204, please refer to FIG. 11B. The LED chips 102, 104 and the conductive electrodes 110, 112 are disposed on the conductive foil 130. As above-mentioned, the light emitting portions of the LED chips 102, 104 are better to align with the openings 132.

Please refer to FIG. 11C. The electrical connection of S22 may be accomplished by wire bonding process like that shown in FIG. 1. As shown in FIG. 11C, the LED chips 102, 104 and the conductive electrodes 110, 112 are electrically connected together in series.

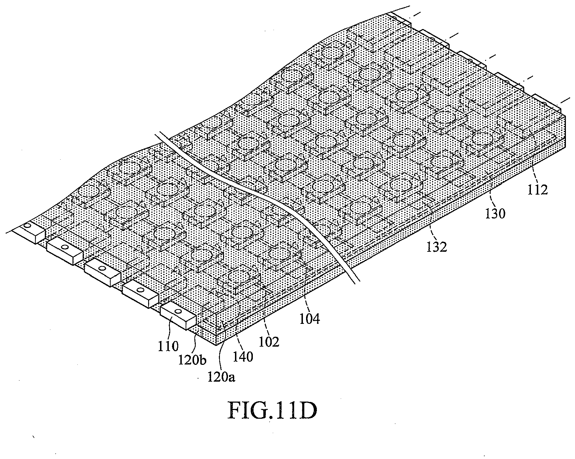

Next, please refer to FIG. 11D. Like the embodiment of FIG. 10, the light conversion sub-layer may be referred to top layer 120a. The top layer 120a fills out the gaps among the LED chips 102, 104 and the conductive electrodes 110, 112 including the gaps under the LED chips 102, 104 and the openings 132.

Regarding the disposition of the top layer 120a, there are a few method to proceed with. The first one is to coat a mixture of the adhesive 122 and the phosphors 124 on the LED chips 102, 104 and the conductive electrodes 110, 112. The second one is to firstly coat a layer of phosphors 124 on the LED chips 102, 104 and the conductive electrodes 110, 112, and secondly coat a layer of adhesive 122 thereon (two disposition steps). Thereafter, cure the layer of adhesive 122 and the layer of phosphors 124. The third one is to repeat the above two disposition steps until a required thickness is reached. Thereafter, a curing process is proceeded with. In comparison with the three methods, the uniformity of the light conversion coating 120 done by the third method might be better. Additionally, the disposition (coat) of the adhesive 122 or the phosphors 124 may be done by spraying.

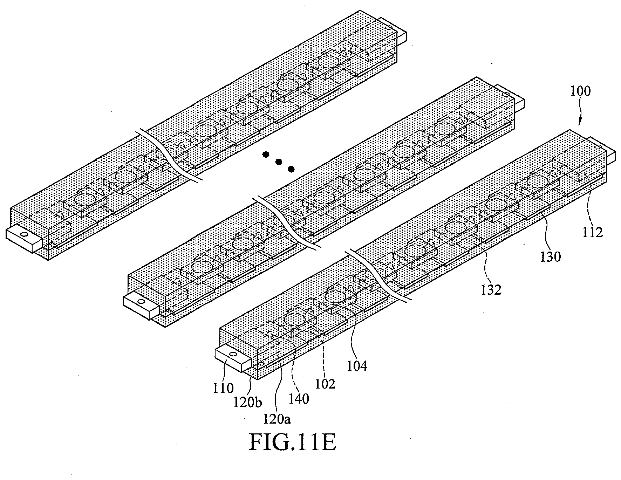

After S24, a cut process may be proceeded with, referring to FIG. 11E. Cut LED filaments 100 are manufactured as shown in FIG. 11E.

In accordance with the embodiment of FIG. 11A to 11E, the LED chips 102, 104 and the conductive electrodes 110, 112 are electrically connected together through conductive foil 130 and conductive wire 140. The flexibility of the electrical connections is enhanced. Accordingly, when the LED filament 100 is bent, the electrical connections would not be easily broken.

Please refer to FIG. 12A and 12B which illustrate a perspective view of LED light bulb applying the LED filaments according to a first and a second embodiments. The LED light bulb 10a, 10b comprises a bulb shell 12, a bulb base 16 connected with the bulb shell 12, at least two conductive supports 14a, 14b disposed in the bulb shell 12, a driving circuit 18 electrically connected with both the conductive supports 14a, 14b and the bulb base 16, and a single LED filament 100 disposed in the bulb shell 12.

The conductive supports 14a, 14b are used for electrically connecting with the conductive electrodes 110, 112 and for supporting the weight of the LED filament 100. The bulb base 16 is used to receive electrical power. The driving circuit 18 receives the power from the bulb base 16 and drives the LED filament 100 to emit light. Due that the LED filament 100 emits light like the way a point light source does, the LED bulb 10a, 10b may emit omnidirectional light. In this embodiment, the driving circuit 18 is disposed inside the LED light bulb. However, in some embodiments, the driving circuit 18 may be disposed outside the LED bulb.

The definition of the omnidirectional light depends upon the area the bulb is used and varies over time. The definition of the omnidirectional light may be, but not limited to, the following example. Page 24 of Eligibility Criteria version 1.0 of US Energy Star Program Requirements for Lamps (Light Bulbs) defines omnidirectional lamp in base-up position requires that light emitted from the zone of 135 degree to 180 degree should be at least 5% of total flux (lm), and 90% of the measured intensity values may vary by no more than 25% from the average of all measured values in all planes (luminous intensity (cd) is measured within each vertical plane at a 5 degree vertical angle increment (maximum) from 0 degree to 135 degree). JEL 801 of Japan regulates the flux from the zone within 120 degrees along the light axis should be not less than 70% of total flux of the bulb.

In the embodiment of FIG. 12A, the LED light bulb 10a comprises two conductive supports 14a, 14b. In an embodiment, the LED light bulb may comprise more than two conductive supports 14a, 14b depending upon the design.

The bulb shell 12 may be shell having better light transmittance and thermal conductivity; for example, but not limited to, glass or plastic shell. Considering a requirement of low color temperature light bulb on the market, the interior of the bulb shell 12 may be appropriately doped with a golden yellow material or a surface inside the bulb shell 12 may be plated a golden yellow thin film for appropriately absorbing a trace of blue light emitted by a part of the LED chips 102, 104, so as to downgrade the color temperature performance of the LED bulb 10a, 10b. A vacuum pump may swap the air as the nitrogen gas or a mixture of nitrogen gas and helium gas in an appropriate proportion in the interior of the bulb shell 12, so as to improve the thermal conductivity of the gas inside the bulb shell 12 and also remove the water mist in the air. The air filled within the bulb shell 12 may be at least one selected from the group substantially consisting of helium (He), and hydrogen (H2). The volume ratio of Hydrogen to the overall volume of the bulb shell 12 is from 5% to 50%. The air pressure inside the bulb shell may be 0.4 to 1.0 atm (atmosphere).

According to the embodiments of FIG. 12A and 12B, each of the LED light bulbs 10a, 10b comprises a stem 19 in the bulb shell 12 and a heat dissipating element 17 between the bulb shell 12 and the bulb base 16. In the embodiment, the bulb base 16 is indirectly connected with the bulb shell 12 via the heat dissipating element 17. Alternatively, the bulb base 16 can be directly connected with the bulb shell 12 without the heat dissipating element 17. The LED filament 100 is connected with the stem 19 through the conductive supports 14a, 14b. The stem 19 may be used to swap the air inside the bulb shell 12 with nitrogen gas or a mixture of nitrogen gas and helium gas. The stem 19 may further provide heat conduction effect from the LED filament 100 to outside of the bulb shell 12. The heat dissipating element 17 may be a hollow cylinder surrounding the opening of the bulb shell 12, and the interior of the heat dissipating element 17 may be equipped with the driving circuit 18. The exterior of the heat dissipating element 17 contacts outside gas for thermal conduction. The material of the heat dissipating element 17 may be at least one selected from a metal, a ceramic, and a plastic with a good thermal conductivity effect. The heat dissipating element 17 and the stem 19 may be integrally formed in one piece to obtain better thermal conductivity in comparison with the traditional LED light bulb whose thermal resistance is increased due that the screw of the bulb base is glued with the heat dissipating element.

Referring to FIG. 12A, the height of the heat dissipating element 17 is L1 and the height from the bottom of the heat dissipating element 17 to the top of the bulb shell 12 is L2. The ratio of L1 to L2 is from 1/30 to 1/3. The lower the ratio, the higher the cutoff angle of illumination of the light bulb. In other words, the lower ratio increases the higher light-emission angle and the light from the bulb is closer to omnidirectional light.

Please referring to FIG. 12B, the LED filament 100 is bent to form a portion of a contour and to form a wave shape having wave crests and wave troughs. In the embodiment, the outline of the LED filament 100 is a circle when being observed in a top view and the LED filament 100 has the wave shape when being observed in a side view. Alternatively, the outline of the LED filament 100 can be a wave shape or a petal shape when being observed in a top view and the LED filament 100 can have the wave shape or a line shape when being observed in a side view. In order to appropriately support the LED filament 100, the LED light bulb 10b further comprises a plurality of supporting arms 15 which are connected with and supports the LED filament 100. The supporting arms 15 may be connected with the wave crest and wave trough of the waved shaped LED filament 100. In this embodiment, the arc formed by the filament 100 is around 270 degrees. However, in other embodiment, the arc formed by the filament 100 may be approximately 360 degrees. Alternatively, one LED light bulb 10b may comprise two LED filaments 100 or more. For example, one LED light bulb 10b may comprise two LED filaments 100 and each of the LED filaments 100 is bent to form approximately 180 degrees arc (semicircle). Two semicircle LED filaments 100 are disposed together to form an approximately 360 circle. By the way of adjusting the arc formed by the LED filament 100, the LED filament 100 may provide with omnidirectional light. Further, the structure of one-piece filament simplifies the manufacturing and assembly procedures and reduces the overall cost.

In some embodiment, the supporting arm 15 and the stem 19 may be coated with high reflective materials, for example, a material with white color. Taking heat dissipating characteristics into consideration, the high reflective materials may be a material having good absorption for heat radiation like graphene. Specifically, the supporting arm 15 and the stem 19 may be coated with a thin film of graphene.

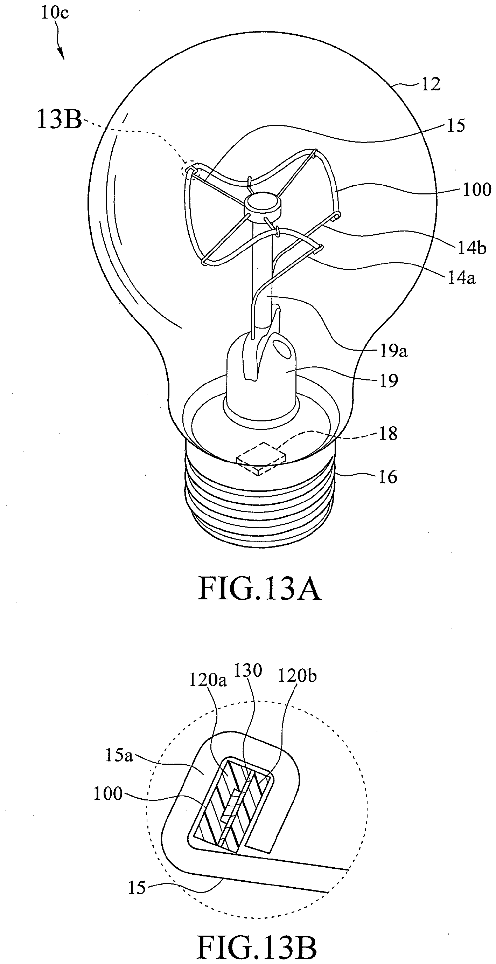

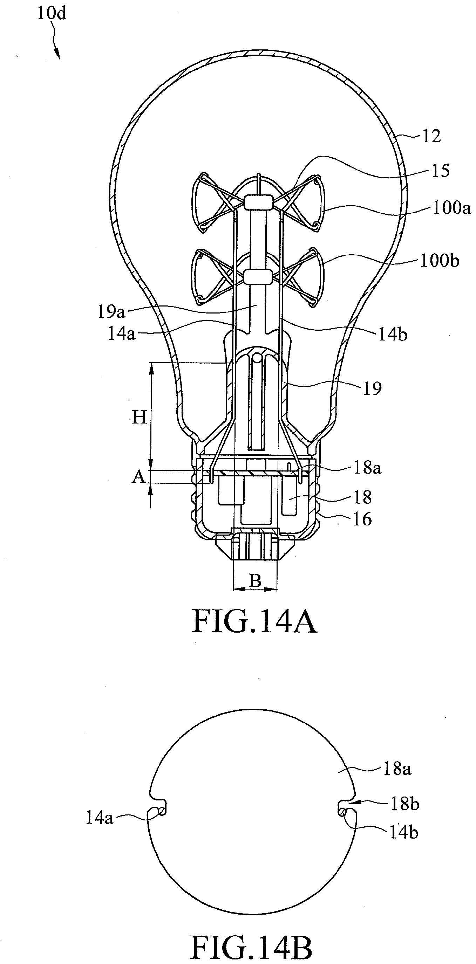

Please refer to FIG. 13A and FIG. 14A. FIG. 13A illustrates a perspective view of an LED light bulb according to a third embodiment of the present disclosure. FIG. 14A illustrates a cross-sectional view of an LED light bulb according to a fourth embodiment of the present disclosure. According to the third embodiment, the LED light bulb 10c comprises a bulb shell 12, a bulb base 16 connected with the bulb shell 12, two conductive supports 14a, 14b disposed in the bulb shell 12, a driving circuit 18 electrically connected with both the conductive supports 14a, 14b and the bulb base 16, a stem 19, supporting arms 15 and a single LED filament 100. The LED light bulb 10d of the fourth embodiment is similar to the third embodiment illustrated in FIG. 13A and comprises two LED filaments 100a, 100b arranged at the different vertical level in FIG. 14A. The LED filaments 100a, 100b are bent to form a contour from the top view of FIG. 14A.

The cross-sectional size of the LED filaments 100, 100a, 100b is small than that in the embodiments of FIG. 12A and 12B. The conductive electrodes 110, 112 of the LED filaments 100, 100a, 100b are electrically connected with the conductive supports 14a, 14b to receive the electrical power from the driving circuit 18. The connection between the conductive supports 14a, 14b and the conductive electrodes 110, 112 may be a mechanical pressed connection or soldering connection. The mechanical connection may be formed by firstly passing the conductive supports 14a, 14b through the through holes 111, 113 (shown in FIG. 1 and secondly bending the free end of the conductive supports 14a, 14b to grip the conductive electrodes 110, 112. The soldering connection may be done by a soldering process with a silver-based alloy, a silver solder, a tin solder.

Similar to the first and second embodiments shown in FIGs. 12A and 12B, each of the LED filaments 100, 100a, 100b is bent to form a contour from the top view of FIGs. 13A and 14A. In the embodiments of FIGs. 13A, 14A, each of the LED filaments 100, 100a, 100b is bent to form a wave shape from side view. The shape of the LED filament 100 is novel and makes the illumination more uniform. In comparison with a LED bulb having multiple LED filaments, single LED filament 100 has less connecting spots. In implementation, single LED filament 100 has only two connecting spots such that the probability of defect soldering or defect mechanical pressing is decreased.

The stem 19 has a stand 19a extending to the center of the bulb shell 12. The stand 19a supports the supporting arms 15. The first end of each of the supporting arms 15 is connected with the stand 19a while the second end of each of the supporting arms 15 is connected with the LED filament 100, 100a, 100b. Please refer to FIG. 13B which illustrates an enlarged cross-sectional view of the dashed-line circle of FIG. 13A. The second end of each of the supporting arms 15 has a clamping portion 15a which clamps the body of the LED filament 100, 100a, 100b. The clamping portion 15a may, but not limited to, clamp at either the wave crest or the wave trough. Alternatively, the clamping portion 15a may clamp at the portion between the wave crest and the wave trough. The shape of the clamping portion 15a may be tightly fitted with the outer shape of the cross-section of the LED filament 100, 100a, 100b. The dimension of the inner shape (through hole) of the clamping portion 15a may be a little bit smaller than the outer shape of the cross-section of the LED filament 100, 100a, 100b. During manufacturing process, the LED filament 100, 100a, 100b may be passed through the inner shape of the clamping portion 15a to form a tight fit. Alternatively, the clamping portion 15a may be formed by a bending process. Specifically, the LED filament 100, 100a, 100b may be placed on the second end of the supporting arm 15 and a clamping tooling is used to bend the second end into the clamping portion to clamp the LED filament 100, 100a, 100b.

The supporting arms 15 may be, but not limited to, made of carbon steel spring to provide with adequate rigidity and flexibility so that the shock to the LED light bulb caused by external vibrations is absorbed and the LED filament 100 is not easily to be deformed. Since the stand 19a extending to the center of the bulb shell 12 and the supporting arms 15 are connected to a portion of the stand 19a near the top thereof, the position of the LED filaments 100 is at the level close to the center of the bulb shell 12. Accordingly, the illumination characteristics of the LED light bulb 10c are close to that of the traditional light bulb including illumination brightness. The illumination uniformity of LED light bulb 10c is better. In the embodiment, at least a half of the LED filaments 100 is around a center axle of the LED light bulb 10c. The center axle is coaxial with the axle of the stand 19a.

In the embodiment, the first end of the supporting arm 15 is connected with the stand 19a of the stem 19. The clamping portion of the second end of the supporting arm 15 is connected with the outer insulation surface of the LED filaments 100, 100a, 100b such that the supporting arms 15 are not used as connections for electrical power transmission. In an embodiment where the stem 19 is made of glass, the stem 19 would not be cracked or exploded because of the thermal expansion of the supporting arms 15 of the LED light bulb 10c.

Since the inner shape (shape of through hole) of the clamping portion 15a fits the outer shape of the cross-section of the LED filament 100, the orientation of the cross-section of the LED filament 100, if necessary, may be properly adjusted. As shown in FIG. 13B, the top layer 120a is fixed to face around ten o'clock direction such that illumination surfaces of the LED filament 100 are facing substantially the same direction.

Please refer to FIG. 14B which illustrates the circuit board of the driving circuit of the LED light bulb from the top view of FIG. 14A according to the fourth embodiment of the present disclosure. The driving circuit 18 comprises a circuit board 18a which is fixed to the bulb base 16. The conductive supports 14a, 14b are electrically connected with the circuit board 18a and passes through the stand 19a to be electrically connected with the conductive electrodes 110, 112 of the LED filament 100a, 100b. The circuit board 18a comprises notches 18b. The notches 18b are of hook shape. The size of the tip of the notches 18b is slightly smaller than that of the cross-section of the conductive supports 14a, 14b for fixing the conductive supports 14a, 14b. The tip of the notches 18b is beneficial to the soldering between the circuit board 18a and the conductive supports 14a, 14b.

In the embodiments of FIGs. 13A and 14A, the length of the conductive supports 14a, 14b is better to meet the below equation to prevent two conductive supports 14a, 14b from short circuit or to prevent the conductive supports 14a, 14b from unable to reach the circuit board 18a.

$$L = A + \sqrt{[(B-3.2)]^2 + H^2}$$

Wherein, referring to FIG. 14A, 3.2 is the electricity safety spacing; L is the calculated length of the conductive supports 14a, 14b and its unit is mini-meter; A is the sum of the thickness of the circuit board 18a and the height of the portion of the conductive supports 14a, 14b exposed from the surface of the circuit board 18a; B is the horizontal distance between the two conductive supports 14a, 14b; and H is the height from the circuit board 18a to the point the conductive supports 14a, 14b enters the stem 19. The actual length of the conductive supports 14a, 14b may be, but not limited to, between 0.5L and 2L, and more particularly between 0.75L and 1.5L.

In the embodiment of FIG. 14A, the LED light bulb 10d has two LED filaments 100a, 100b disposed on different vertical levels. The conductive supports 14a, 14b for the upper LED filaments 100a has a length Z=L + Y. Y is the distance between the upper LED filament 100a and the lower LED filament 100b.

Referring to Fig. 17A, the LED filament 400a comprises a linear array of LED chips 402, 404, conductive electrodes 410, 412, conductive wires 440 for electrically connecting the adjacent LED chips 402, 404 and conductive electrodes 410, 412, and light conversion coating 420 coating on at least two sides of the LED chips 402, 404 and the conductive electrodes 410, 412. The light conversion coating 420 exposes a portion of two of the conductive electrodes 410, 412. The light conversion coating 420 comprises a top layer 420a and a base layer 420b. The base layer 420b coats on one side of the LED chips 402, 404 and the conductive electrodes 410, 412. The top layer 420a coats on another sides of the LED chips 402, 404 and the conductive electrodes 410, 412.

The top layer 420a and the base layer 420b is differentiable by a manufacturing procedure of the LED filament 400a. During a manufacturing procedure, the base layer 420b can be formed in advance. Next, the LED chips 402, 404 and the conductive electrodes 410, 412 can be disposed on the base layer 420b. The LED chips 402, 404 are connected to the base layer 420b via die bond glues 450. The conductive wires 440 can be formed between the adjacent LED chips 402, 404 and conductive electrodes 410, 412. Finally, the top layer 420a is coated on the LED chips 402, 404 and the conductive electrodes 410, 412.

Both of the top layer 420a and the base layer 420b can comprise at least one of phosphor glue layer(s), phosphor film layer(s), and transparent layer(s). If the top layer 420a or the base layer 420b comprises a transparent layer, it may comprise the other phosphor glue/film layer(s). In some embodiments, the surface roughness Rz of the phosphor film layer may be from 1 $\mu$m to 2mm, and the surface roughness Rz of the phosphor glue layer may be from 1nm to 200$\mu$m.

Each of the layers of the phosphor glue layer(s) and the phosphor film layer(s) of the top layer 420a and the base layer 420b can comprise an adhesive, phosphors, and may preferably further comprise inorganic oxide nanoparticles (optional). The transmittance of visible light of the transparent layer can be greater than 40%. The transparent layer can be formed by adhesive made of a silica gel, a silicone resin, a polyimide (PI) gel, the like or a combination thereof. The adhesive with the PI gel is harder than that formed by silicone resin only. The phosphors or the inorganic oxide nanoparticles in different phosphor glue layers or phosphor film layers can have different sizes or densities and can be made by varied materials depending on needs. Different phosphor glue layers or phosphor film layers can have varied thickness. According to the adhesive, the phosphors, the inorganic oxide nanoparticles, or other possible elements, the phosphor glue layer or phosphor film layer can have different hardness and wavelength conversion properties. The percent transmittance of the phosphor glue layer or the phosphor film layer of the top layer 420a or the base layer 420b can be varied depending on needs. For example, the percent transmittance of the phosphor glue layer or the phosphor film layer of the top layer 420a or the base layer 420b can be greater than 20%, 50%, or 70%. The layers of the top layer 420a or the base layer 420 can have different transmittance.

It should be understood that when the top layer 420a or the base layer 420b comprise continuous layers of same definition, at least one property of the continuous layers capable of being distinct from one layer to another layer should exist between the continuous layers. For example, when the two continuous layers are phosphor glue layers or phosphor film layers, the properties (e.g. particle size, wavelength conversion properties, ingredient proportion, thickness, hardness, etc.) of the continuous may be different. When the two continuous layers are transparent layers, the properties (e.g. adhesive type, thickness, ingredient proportion, optical properties like transmittance, refraction index, etc.) of the continuous transparent layers may be different.

In the embodiment, the top layer 420a is the phosphor glue layer, and the base layer 420b is the phosphor film layer. The phosphor glue layer comprises an adhesive 422, a plurality of phosphors 424, and a plurality of inorganic oxide nanoparticles 426. The adhesive 422 may be silica gel or silicone resin. The plurality of the inorganic oxide nanoparticles 426 may be, but not limited to, aluminium oxides (Al2O3). The phosphor film layer comprises an adhesive 422', a plurality of phosphors 424', and a plurality of inorganic oxide nanoparticles 426'. The compositions of the adhesives 422 and adhesive 422' may be different. The adhesive 422' may be harder than the adhesive 422 to facilitate the disposition of the LED chips 402, 404 and the conductive wires 440. For example, the adhesive 422 may be silicone resin, and the adhesive 422' may be a combination of silicone resin and PI gel. The mass ratio of the PI gel of the adhesive 422' can be equal to or less than 10%. The PI gel can strengthen the hardness of the adhesive 422'. The plurality of the inorganic oxide nanoparticles 426 may be, but not limited to, aluminium oxides (Al2O3). The size of the phosphors 424' may be smaller than that of the phosphors 424. The size of the inorganic oxide nanoparticles 426' may be smaller than that of the inorganic oxide nanoparticles 426. The size of inorganic oxide nanoparticles may be around 100 to 600 nanometers (nm). The inorganic oxide nanoparticle is beneficial to heat dissipating.

The Shore Hardness of the phosphor glue layer may be D40-70. The Shore Hardness of the phosphor film layer may be D20-70. The thickness of the phosphor film layer is substantially between 0.1 mm and 0.5 mm. The index of refraction of the phosphor film layer is substantially equal to or greater than 1.4. The percent transmittance of the phosphor film layer is substantially equal to or greater than 95%. The adhesive may be mixed with polyimide (PI) gel (WT% of the PI gel is substantially equal to or less than 10%) to form the light conversion coating 420 to improve the toughness of the light conversion coating 420 and to reduce possibility of cracking or embrittlement. The PI gel is highly electrically insulated and is insensitive to temperature. In some embodiments, the solid content of the PI gel in terms of WT% is substantially between 5% and 40%. The rotation viscosity of the PI gel may be substantially between 5 Pa.s and 20 Pa.s.

Please refer to FIG. 17B. FIG. 17B illustrates a cross-sectional view of an LED filament 400b according to an embodiment of the present disclosure. The LED filament 400b is analogous to and can be referred to the LED filament 400a. In the embodiment, the LED chips 402, 404, the conductive wires 440, and the top layer 420a are disposed on two opposite sides of the base layer 420b. In other words, the base layer 420b is between the two top layers 420a. The conductive electrodes 410, 412 are at two opposite ends of the base layer 420b. The LED chips 402 of both of the two top layers 420a can be connected to the same conductive electrodes 410, 412 via the conductive wires 440.

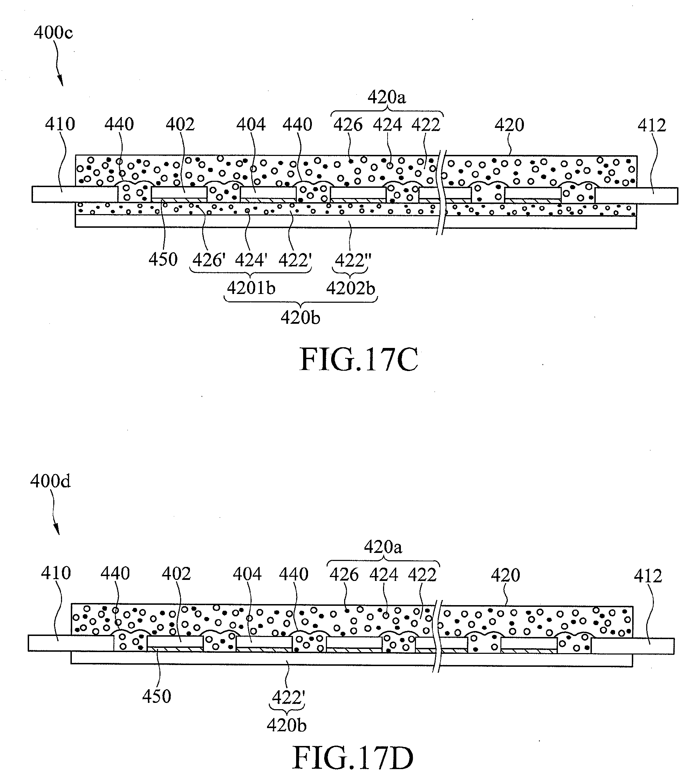

Please refer to Fig. 17C. Fig. 17C illustrates a cross-sectional view of an LED filament 400c according to an embodiment of the present disclosure. The LED filament 400c is analogous to and can be referred to the LED filament 400a. In the embodiments, the base layer 420b of the LED filament 400c is further divided into a phosphor film layer 4201b and a transparent layer 4202b with different hardness. The phosphor film layer 4201b may be harder than the transparent layer 4202b. The harder layer (i.e., the phosphor film layer 4201b) of the base layer 420b is between the softer layer (i.e., the transparent layer 4202b) of the base layer 420b and the top layer 420a. The harder layer is a layer on which the LED chips 402, 404 and the conductive electrodes 410, 412 are directly disposed. Due to the greater hardness of the harder layer, the disposition of the LED chips 402, 404, the conductive electrodes 410, 412, and the conductive wires 440 is easier. Due to the greater flexibility of the softer layer, the light conversion coating 420 is still of toughness. In the embodiment, the phosphor film layer 4201b comprises the adhesive 422' mixed with the PI gel. The transparent layer 4202b comprises an adhesive 422" only. The adhesive 422" may be silicone resin. The transparent layer 4202b may be of highest transmittance than other layers.

In some embodiment, the transparent layers can function as one or more refraction-altering layers, which can alter the index of refraction so that the angle of emergence of light rays emitted from the LED chips 402, 404, the phosphor film layer 4201b and penetrating through the transparent layer(s) is adjustable. For example, the thickness of the transparent 4202b may be 1/4 wavelength of optical thickness and may be different according to the wavelength of light; therefore, interference phenomenon may occur due to multiple reflection of interfaces (e.g. interfaces between LED chip 402, 404 and the phosphor film layer 4201b, the phosphor film layer 4201b and the transparent layer 4202b, and the transparent layer 4202b and the atmosphere), and thus the reflected light may be reduced. In some embodiments, the number of transparent layers may be more than one. For example, when there are two or three transparent layers, the reflectivity may be lower. For example, when there are three transparent layers respectively with 1/4, 1/2, and 1/4 wavelength of thickness, it can bring the effect of wideband low reflection. In some embodiments, the thickness of transparent layer may be regulated according to different wavelengths of LED chips, the phosphor glue layers, the phosphor film layers within a range of the ratio to reduce the interference phenomenon. For example, the thickness of the transparent layer may be $\pm 20\%$ of 1/2, 1/4 wavelength. The thickness of the transparent layer may be regulated according to the inner layer thereof (e.g. LED chip, the phosphor glue layer, or the phosphor film layer). It refers to mainly regulate the waveband of emergent light that the luminous intensity is greater than 60% (preferably 80%) of the luminous intensity of total wavelength. The material of the transparent layer may be selected from materials with the index of refraction within $\pm 20\%$ of square root of the index of refraction of the inner layer. For example, when the index of refraction of the phosphor film layer 4201b (i.e. the inner layer of the transparent layer 4202b) is 2, the index of refraction of the transparent layer 4202b will be $1.414 \pm 20\%$. Hence, loss of light reflection can be reduced efficiently.

In some embodiments, the Shore hardness of the phosphor film layer 4201b equals to 40 plus the Shore hardness of the transparent layer 4202b. The shore hardness of the transparent layer 4202b is D20-40.

In some embodiment, the base layer 420b may be further divided into two layers with different thickness.

Please refer to FIG. 17D. FIG. 17D illustrates a cross-sectional view of an LED filament 400d according to an embodiment of the present disclosure. The LED filament 400d is analogous to and can be referred to the LED filament 400a. A difference between the LED filament 400d and 400a is that the base layer 420b of the LED filament 400d comprises an adhesive 422' only. The adhesive 422' may be silicone resin mixed with PI gel to increase the hardness of the base layer 420b so as to facilitate the deposition of the LED chips 402, 404, the conductive electrodes 410, 412, and the conductive wires 440. The base layer 420b may be of highest transmittance than other layers.

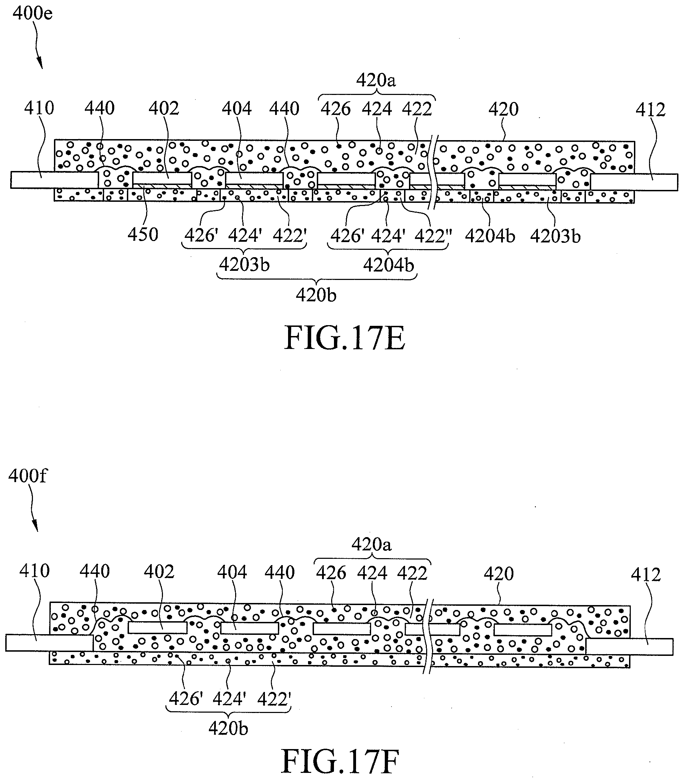

Please refer to Fig. 17E. Fig. 17E illustrates a cross-sectional view of an LED filament 400e according to an embodiment of the present disclosure. The LED filament 400e is analogous to and can be referred to the LED filament 400a. A difference between the LED filament 400e and 400a is that the base layer 420b of the LED filament 400e is divided into different sections (not layers). The base layer 420b of the LED filament 400e is divided into alternating hard portions 4203b and soft portions 4204b. The hard portions 4203b and the soft portions 4204b are arranged in a staggered manner. The hard portions 4203b comprise an adhesive 422', phosphors 424', and inorganic oxide nanoparticles 426'. The soft portions 4204b comprise an adhesive 422", phosphors 424', and inorganic oxide nanoparticles 426'. The adhesive 422' can be PI gel or silicone resin mixed with PI gel, and the adhesive 422" can be silicone resin without PI gel; therefore, the hard portions 4203b is harder than the soft portion 4204b. The hard portions 4203b are aligned with the LED chips 402, 404 and the conductive electrodes 410, 412, which facilitates the disposition of the LED chips 402, 404 and the conductive electrodes 410, 412. The soft portions 4204b can improve the flexibility of the base layer 420b. In some embodiments (not shown), a flexible LED filament installed in an LED light bulb can be defined as, for example, three parts according to their positions related to a bulb base or a stem of the LED light bulb. A part of the flexible LED filament the closest to the bulb base or the stem is defined as a bottom segment. A part of the flexible LED filament the farthest to the bulb base or the stem is defined as a top segment. A part of the flexible LED filament between the bottom segment and the top segment is defined as a middle segment. The curvatures of shapes of each of the top segment, the middle segment, and the bottom segment being bent can be defined as, for example, three degrees, which are the highest one, the lowest one, and an average one. As needed, the bottom segment, the top segment, or the middle segment can be formed with different ingredient/proportion and thus have the different curvature.

Please refer to Fig. 17F. Fig. 17F illustrates a cross-sectional view of an LED filament 400f according to an embodiment of the present disclosure. The LED filament 400f is analogous to and can be referred to the LED filament 400a. A difference between the LED filament 400f and 400a is that the LED chips 402, 404 are enclosed by the top layer 420a. The top layer 420a directly contacts each side of the LED chips 402, 404. The base layer 420b does not contact the LED chips 402, 404. During a manufacturing procedure, the base layer 420b can be formed in advance, and then the LED chips 402, 404 and the top layer 420a can be formed.

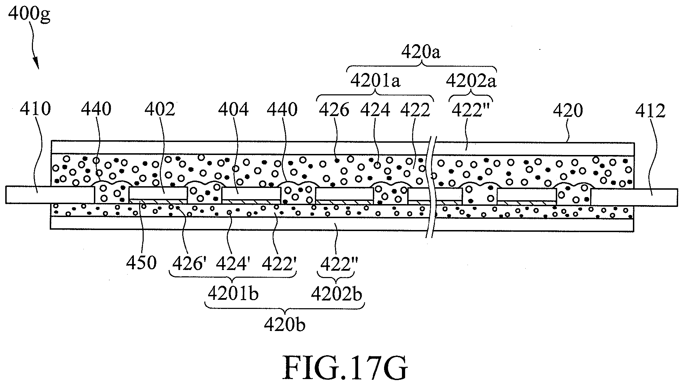

Please refer to FIG. 17G. FIG. 17G illustrates a cross-sectional view of an LED filament 400g according to the invention. The LED filament 400g is analogous to and can be referred to the LED filament 400c. A difference between the LED filament 400g and 400c is that the top layer 420a of the LED filament 400g is further divided into two layers, a phosphor glue layer 4201a and a transparent layer 4202a. The phosphor glue layer 4201a comprises an adhesive 422, phosphors 424, and inorganic oxide nanoparticles 426. The transparent layer 4202a comprises an adhesive 422" only. The transparent layer 4202a may be of highest transmittance than other layers and can protect the phosphor glue layer 4201a. In some embodiments (not shown), the transparent layer 4202a encloses the phosphor glue layer 4201a, i.e., all sides of the phosphor glue layer 4201a except the one adjacent to the phosphor film layer 4201b are covered by the transparent layer 4202a. Additionally, the transparent layer 4202b encloses the phosphor film layer 4201b, i.e., all sides of the phosphor film layer 4201b except the one adjacent to the phosphor glue layer 4201a are covered by the transparent layer 4202b. The transparent layers 4202a, 4202b not only protect the phosphor glue layer 4201a and the phosphor film layer 4201b but also strengthen the whole structure of the LED filament. Preferably, the transparent layer 4202a, 4202b may be thermal shrink film with high transmittance.

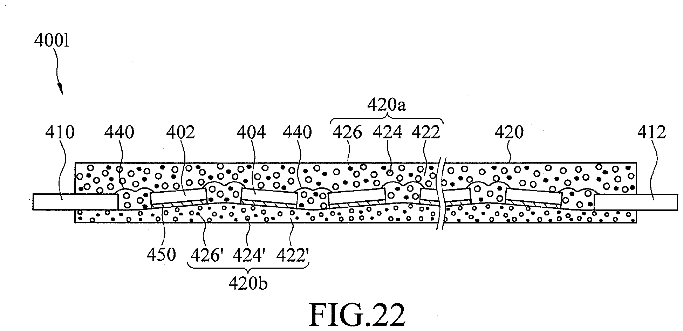

Please refer to FIG. 22. FIG. 22 illustrates a cross-sectional view of an LED filament 400l according to an embodiment of the present disclosure. The LED filament 400l can be referred to the LED filament 400a. A difference between the LED filament 400l and the LED filament 400a is regarding the alignment of the LED chips 402, 404. The LED chips 402, 404 of the LED filament 400a are aligned along a direction from the conductive electrode 410 to the conductive electrode 412 and parallel with a horizontal plane on which the base layer 420b of the LED filament 400a is laid (referring to FIG. 17A). In contrast, the LED chips 402, 404 of the LED filament 400l are not aligned along a direction from the conductive electrode 410 to the conductive electrode 412 and not parallel with a horizontal plane on which the base layer 420b of the LED filament 400l is laid (referring to FIG. 22). The LED chips 402, 404 of the LED filament 400l may respectively have different angles related to the horizontal plane. Correspondingly, the illuminating directions of the LED chips 402, 404 may be different from one another. Under the circumstances, a side of the base layer 420b of the LED filament 400l carrying the LED chips 402, 404 (or the die bond glues 450) may be not a flat plane but may be a successively concave-convex plane so that each of the LED chips 402, 404 disposed on different positions of the successively concave-convex plane have different angles, accordingly. In some embodiments, all of the LED chips 402, 404 of the LED filament 400l have angles related to the horizontal plane different from one another. Alternatively, a part of the LED chips 402, 404 of the LED filament 400l have a first angle related to the horizontal plane, and another part of LED chips 402, 404 of the LED filament 400l have a second angle related to the horizontal plane. In some embodiments, the first angle equals to 180 degrees minus the second angle. Additionally, the LED chips 402, 404 of the LED filament 400l may have different heights related to the horizontal plane. As a result, the LED filament 400l with the LED chips 402, 404 having different illuminating directions (different angles related to the horizontal plane) and/or different heights may generate a more even illumination, such as an omni-directional illumination.

While the instant disclosure related to an LED filament and LED light bulb has been described by way of examples and in terms of the preferred embodiments, it is to be understood that the instant disclosure needs not be limited to the disclosed embodiments. The covered scope of the instant disclosure is based on the appended claims.

The LED filament includes a tubular enclosure, a linear array of LED devices and an electrical connector. The linear array of LED devices is disposed in the tubular enclosure to be operable to emit light when energized through the electrical connector. The shape of a tubular enclosure is either straight or curvaceous. The cross section of a tubular enclosure can take any regular shapes (e.g. circle and polygon) or irregular shapes (e.g. petal and star). The tubular enclosure is a straight cylinder having a circular cross section. The tubular enclosure is made of any optically transmissive material through which optical radiation from the LED devices can pass without being totally absorbed or reflected, e.g. glass, plastic, resin and silicone.

The linear array of LED devices is formed by electrically connecting a plurality of LED devices in parallel, in series or in a combination of both ways. For example, the linear array of LED devices is formed by serially connecting a plurality of LED devices. The linear array of LED devices defines a straight line in the tubular enclosure. The linear array of LED devices defines a U-shaped curve in the tubular enclosure. exactly two linear arrays of LED devices are formed by parallelly connecting a first set of serially connected LED devices and a second set of serially connected LED devices. The pair of linear arrays of LED devices define a pair of parallel straight lines in the tubular enclosure. Because there is only one path in which the current can flow in a series circuit, opening or breaking the circuit at any point causes the entire array of LED devices to stop operating. By contrast, the same voltage is applicable to all circuit components connected in parallel. The total current is the sum of the currents through the individual components. Other things equal including luminary output, lower current in an individual LED device results in better thermal performance.

In some embodiments, the linear array of LED devices are a plurality of individual LED dies connected by conductive glue, solder or welds. LEDs having different colors can be mixed together to create white light. In other embodiments, the linear array of LED devices are a plurality of multi-die LED devices coupled together by a wire frame structure or in some other manner. The linear array of LED devices emit light in a substantially omnidirectional or 360-degree pattern so that light is given off around the tubular enclosure roughly perpendicular to the envelope of the tubular enclosure in all directions.

While the desired light intensity distribution may comprise any light intensity distribution, in one embodiment the desired light intensity distribution conforms to the JEL801 standards or ENERGY STAR® Partnership Agreement Requirements for Luminous Intensity Distribution. Under ENERGY STAR®, an omnidirectional lamp is one configured to emit "an even distribution of luminous intensity (candelas) within the 0° to 135° zone (vertically axially symmetrical). Luminous intensity at any angle within this zone shall not differ from the mean luminous intensity for the entire 0° to 135° zone by more than 20%. At least 5% of total flux (lumens) must be emitted in the 135°-180° zone. Distribution shall be vertically symmetrical as measures in three vertical planes at 0°, 45°, and 90°."

In some embodiments, the tubular enclosure is formed directly on the linear array of LED devices by dispensing a liquid polymer coating containing various particles. The coating formed this way, however, may be unduly thick or undesirably nonuniform. In other embodiments, the tubular enclosure is fabricated and tested independently of the LED devices. Subsequently, the tubular enclosure is adhesively bonded to the LED devices during assembly. Bonding may be direct via a single adhesive layer or via one or more intermediate adhesive layers to form a LED filament in a unitary structure of the linear array of LED devices and the tubular enclosure. In an embodiment, the tubular enclosure is combined with the LED device at the wafer or chip level. Alternatively, tubular enclosure is mounted onto the LED device. The production cost of the LED filament decreases by forming the tubular enclosure separately because defective tubular enclosure can be identified and discarded before packaging. Optionally, the tubular enclosure is sized to fit the lighting surface of the LED device. Moreover, the surface of the tubular enclosure can be textured or patterned to improve light extraction from the LED device by reducing the effects of total internal reflection at the interface of the tubular enclosure with adjacent media such as air or the LED device.

The electrical connector is electrically connected to the linear array of LED devices and is configured to receive electrical power for energizing the linear array of LED devices. The number, shape and position of the electrical connectors depends on intended purposes of an application. For example, the electrical connector includes a metallic pin. A portion of the pin is rooted in the tubular enclosure in electrical connection with the linear array of LED devices. The other portion of the pin sticks out from the tubular enclosure for receiving electrical power. Alternatively, the electrical connector includes a metallic hook. The shank of the hook is rooted in the tubular enclosure in electrical connection with the linear array of LED devices. The throat of the hook sticks out from the tubular enclosure for receiving electrical power. Alternatively, the electrical connector includes a metallic fastener such as binder or clip for physically and electrically attaching to the power source. Alternatively, the electrical connector includes a metallic receptacle. The well of the receptacle is embedded in the tubular enclosure in electrical connection with the linear array of LED devices. The opening of the receptacle is pluggable by a male element for receiving electrical power. The tubular enclosure includes exactly two electrical connectors. A first electrical connector, which is attached to a first end of the tubular enclosure, is positive. A second electrical connector, which is attached to a second end of the tubular enclosure, is negative. The tubular enclosure includes exactly two electrical connectors. A first electrical connector is positive and a second electrical connector is negative. However, both electrical connectors are attached to a same end of the tubular enclosure. The tubular enclosure includes exactly three electrical connectors. A first electrical connector, which is attached to a first end of the tubular enclosure, is the common ground. A second electrical connector, which is attached to a second end of the tubular enclosure, is positive. A third electrical connector, which is also attached to the second end of the tubular enclosure, is positive. The electrical connector is configured to have a shape for properly connecting to the power source for energizing the linear array of the LED devices. Optionally, the electrical connector is further configured to have a proper combination of shape and strength to maintain a posture of the LED filament inside a light bulb. In an embodiment, the electrical connector includes an aperture as a female element for attaching to a male element of the light bulb.

The LED device includes an LED die that comprises a diode layer D and a substrate S. The diode layer D is configured to emit light upon energization, by applying a voltage between an anode contact A and a cathode contact C through the electrical connector. The diode layer D may comprise organic or inorganic materials. In inorganic devices, the substrate S is made of silicon carbide, sapphire or any other single element or compound semiconductor material. The diode layer D comprises silicon carbide, gallium nitride, gallium arsenide, zinc oxide or any other single element or compound semiconductor material, which may be the same as or different from the substrate S. The substrate S is between about 100 $\mu$m and about 250 $\mu$m thick. Thinner and thicker substrates may be used or the substrate may not be used at all. The cathode C and anode A contacts are formed of metal or other conductors, and may be at least partially transparent, reflective or both. Light emission takes place directly from the diode layer D. Alternatively, in an embodiment, light emission takes place from diode layer D through the substrate S. The substrate S is shaped to enhance emission from sidewalls of the substrate S to provide other desirable effects. The substrate itself may be thinned considerably or eliminated entirely, so that only a diode layer D is present. The anode A and the cathode C are provided on opposite sides of the LED die (as). The anode A and the cathode C are provided on the same side of the LED die. In each of the above embodiments, the anode A and cathode C contacts may be of various configurations. Multiple contacts of a given type also may be provided. The linear array of LED devices are electrically connected by electrically connecting the anode and cathode contacts of each of the LED devices in proper sequence. In some embodiments, the anode and cathode contacts are totally absent from the LED device, which includes a p-junction and an n-junction. The linear array of LED devices are electrically connected by electrically connecting the p-junction and the n-junction of each of the LED device in proper sequence.

The LED device comprises a LED die that includes a diode layer D of and may also include a substrate S. The LED device is configured to emit light upon energization through one or more electrical contact, which may include the anode A and the cathode C of. The LED device can emit light of different colors and can also emit radiation outside the visible spectrum such as infrared or ultraviolet. The color of the emitted light is determined by the material properties of the semiconductor used in the LED die. The LED die can be made from many different materials, e.g. gallium nitride (GaN).

Roughening the surface of the LED die increases light extraction of the nitride-based LED device. Texturization can be obtained by using plasma etching directly on the top epilayer. However, the etching process destroys a large portion of the junction, reducing the amount of area in which the light is supposed to be generated. To avoid damaging the thin p-GaN layer, an indiumtin-oxide layer (ITO) can be used as the roughened layer. After completing the traditional planar GaN LED device, the surface of the LED die is texturized using natural lithography, in which the randomly deposited polystyrene spheres (PSs) were distributed as a natural mask for dry etching. After the surface-texturing process, the output power of the GaN LED device is significantly increased as compared to that of the conventional LED devices.

Most of the electricity in an LED device becomes heat rather than light (about 70% heat and 30% light). It is necessary to limit the junction temperature to a value that guarantees a desired lifetime. In some embodiments, the LED device comprises a highpower LED die capable of being loaded at a high voltage but at a lower current. Other things equal, the LED device maintains an acceptable luminary output without comprising thermal performance.

In some embodiments, the LED device has an elongated top view approximating a hypothetical rectangle. Other things equal, the greater the aspect ratio of the hypothetical rectangle, the less likely light gets blocked by opaque components in an LED filament such as electrical contacts and wirings for connecting the electrical contacts. Preferably, the aspect ratio is from 2:1 to 10:1. Examples are 28 $\times$ 14 and 20 $\times$ 10.

Although illustrated as having exactly one LED die, the LED device may be provided to have a plurality of LED dies as well, each of which may be configured to emit the same or different colors of light, mounted on a common substrate. The multi-die device may be grouped on the substrate in clusters or other arrangements such that the LED filament outputs a desired pattern of light. In some embodiments, the multi-die LED devices is configured to provide white light based on the combination of the colors of light emitted by each of its component LED dies. For example, a multi-die LED device is configured to emit light having a spectral distribution including at least four different color peaks (i.e., having local peak wavelengths in wavelength ranges corresponding to at least four different colors of light) to provide the white light.

To produce white light, multiple LED devices emitting light of different colors of light may be used. The light emitted by the LED device is combined to produce white light of a desired intensity, color or both. For example, when red-, green- and blueemitting LED devices are energized simultaneously, the resulting combined light appears white, or nearly white, depending on the relative intensities of the component red, green and blue sources.

In addition, the light from a single-color LED device may be converted to white light by surrounding the LED with a wavelength conversion material, such as phosphor particles. The term "phosphor" may be used herein to refer to any materials that absorb light at one wavelength and re-emit light at a different wavelength, regardless of the delay between absorption and re-emission and regardless of the wavelengths involved. Accordingly, the term "phosphor" is used herein to refer to materials that are sometimes called fluorescent or phosphorescent. In general, phosphors absorb light having shorter wavelengths and re-emit light having longer wavelengths. As such, some or all of the light emitted by the LED device at a first wavelength may be absorbed by the phosphor particles, which may responsively emit light at a second wavelength. For example, a single blue emitting LED device may be surrounded with a yellow phosphor, such as cerium-doped yttrium aluminum garnet (YAG). The resulting light, which is a combination of blue light and yellow light, may appear white to an observer. In an embodiment, the LED die emits blue light. The white light many applications require may be achieved by converting a portion of the blue light into yellow light. When emitted, the combination of blue and yellow light appears white.

The linear array of LED devices are electrically connected to emit light upon energization by applying a voltage through the electrical connector. Electrical connection can be made in a variety of ways depending on the advantages an LED filament is expected to pursue. Examples include wire bonding, conductive glue, flexible printed circuit (FPC) film and any combination of the above. Interconnections between the LED devices are made by wire bonding. The bonding wire is made of copper, gold or any suitable alloy. In some embodiments, the bonding wire includes a spring between the LED devices it connects. When the linear array of LED devices is stretched or compressed in the LED filament, the bonding wire, when shaped like a spring, absorbs the mechanical energy that could otherwise open the circuit of or damage the structure of the linear array of LED devices. Generally, the greater the sinuosity of the bond wire, the more mechanical energy the bond wire is capable of storing. The sinuosity is the ratio of the curvilinear length along the bond wire and the Euclidean distance between the end points of the bond wire. The bonding wire forms a bow-shaped spring between the LED devices it connects. The bonding wire forms a helical spring between the LED devices it connects.

When the tubular enclosure is formed directly on the linear array of LED devices by dispensing a liquid polymer coating on the LED device, a variety of incidents may negatively impact the quality of the LED filament produced through wire bonding. During wire bonding, the bonding wire is attached at both ends to the ohmic contacts of the LED device using a combination of downward pressure, ultrasonic energy, and in some cases heat, to make a weld. The LED device could be inadvertently shattered or burned during wire bonding. Moreover, ohmic contacts of the LED device, if having a tarnished or uneven surface, will drop bond strength and subject the LED filament to potential failure. Furthermore, the bonding could be dislocated when the liquid polymer is being dispensed on the bonding wire attaching, otherwise properly or improperly, to adjacent LED devices. To mitigate such problems, in some embodiments, interconnections between the LED devices are made with glue wires made from electrically conductive glue continuously applied between the anode and cathode contacts of adjacent LED devices. Electrically conductive glue is formed by doping electrically conductive particles in an elastic binder. The electrically conductive particle can be gold or silver. Preferably, the electrically conductive particle are made from optically transmissive materials such as nano-silver, nano-carbon tubes and graphene. In some embodiments, wavelength conversion particles are added to the electrically conductive glue for enhanced light conversion. The elastic binder can be silicone, epoxy or polyimide. Preferably, the elastic binder for the electrically conductive glue is the same material from which the tubular enclosure is made. The glue wire is thus integrated into the tubular enclosure and is made capable of stretching or compressing in perfect sync with the tubular enclosure. The glue wire connecting adjacent LED devices covers substantially the entire surface of the anode and cathode contacts. The glue wire connecting adjacent LED devices partially covers the anode and cathode contacts. The anode and cathode contacts are provided on the same side of the LED die. In addition to being a straight line, the glue wire can be a curve of any kind depending on the application. The glue wire is drawn to define a S-shaped curve between the LED devices it connects in anticipation of deformation resulting from the LED filament being stretched or compressed. When the anode and cathode contacts are not aligned along the longitudinal axis of the linear array of the LED devices, the glue wire can make a turn-for example-at the corner of the LED device 106 to complete an electrical connection to adjacent LED device. The glue wire can be fabricated with the aid of glue dispenser capable of 3-D maneuvers. A platform is formed to fill the gap between adjacent LED devices. Preferably, the platform is made from the same material from which the tubular enclosure is made. The upper surface of the platform provides a continuous path for the glue wire to run from the anode contact of an LED devices to the cathode contact of an adjacent LED device. Alternatively, a mold is made to follow the contour of the anode and cathode contacts of the linear array of LED devices. The mold, when properly deployed, defines a gap between the mold and the linear array of LED devices. The glue wire is formed by filling the gap with electrically conductive glue. In some embodiments, the anode and cathode contacts-blocking light where they are disposed over the diode region-are eliminated from the LED die. The glue wire is thus configured to connect the p-junction of an LED device and the n-junction of an adjacent LED device.

In yet another embodiment, the interconnection between the LED devices is made with a strip of flexible printed circuit (FPC) film. The strip of FPC film includes a plurality of conductive tracks laminated onto a strip of thin and nonconductive substrate. The strip of FPC film mechanically supports the linear array of LED devices with the strip of nonconductive substrate. The conductive track electrically connects the linear array of LED devices by connecting the anode contact of an LED device to the cathode contact of an adjacent LED device. The nonconductive substrate is an optically transmissive film, preferably having transmittance of 92% or more. For example, the nonconductive substrate is a thin film made from Polyimide. The conductive track can be made from electrical conductors such as indium tin oxide (ITO), silver nanoparticles or carbon nanotubes (CNTs). In an embodiment, the conductive track is made from silver nanoparticles doped with gold for reliable connection with the ohmic contact of the LED device. The conductive track can come in many patterns. The conductive track defines a set of slanted parallel lines. The conductive track defines a slanted grid. Preferably, the conductive track has a thickness of from 20 to 100 $\mu$m. Preferably, the line in the set of the parallel lines and the grid has a width of from 20 to 100 $\mu$m. Some light is blocked by the conductive track even when the conductive track is made from transparent materials such as ITO. In some embodiments, the plurality of conductive tracks cover less than 100% of the nonconductive substrate to allow more light to travel both ways through the nonconductive substrate. Preferably, the ratio of the total area covered by the plurality of conductive tracks to the area of the nonconductive substrate is from 0.001 to 0.005. The strip of FPC film is suitable for an LED filament designed to bend. When the conductive track is properly patterned, e.g. a set slanted parallel lines, a reliable electrical connection for the linear array of LED devices is obtained because a broken line would not break the connection.

According to an embodiment of the present invention, which is not claimed, the method of making an LED filament includes the following steps:

S20: Arrange a linear array of LED devices spaced apart from one another and an electrical connector on a mount surface;
S22: Electrically and physically connect the linear array of LED devices and the electrical connector; and
S24: Dispose the linear array of LED devices in a tubular enclosure.

In S20, the mount surface is any surface capable of supporting the linear array of LED devices and the electrical connector throughout the steps of the method. Usually, the mount surface is a substantially planar surface. In some embodiments, the mount surface is a three dimensional surface whose shape depends on a desired totality of considerations such as: the posture the LED filament is expected to maintain in a lighting fixture; the posture each individual LED device is expected to maintain in relation to the rest of the linear array of LED devices; the shape of the tubular enclosure; the texture of the outer surface of the tubular enclosure; and the position of the linear array of LED devices in the tubular enclosure. Each of the linear array of LED devices is properly aligned with adjacent LED devices on the mount surface depending on the position of the anode and cathode contacts on the LED device and depending on the type of electrical connection to be made for the linear array of LED devices in S22. In S22, the electrical connection is made with bond wire, conductive glue, FPC film or a combination of the above. The linear array of LED devices is electrically connected in parallel, in series or in a combination of both ways.

In some embodiments where a cluster of LED filaments is assembled on a large mount surface, the method of making an LED filament further includes the following step:

S26: Depanel the cluster of LED filaments.

In S26, an LED filament depaneled from the cluster may include a linear array of LED devices or a plurality of linear arrays of LED devices depending on the application.

In an embodiment, the tubular enclosure is made from a cured transparent binder such as a cured transparent polymer. The tubular enclosure includes a first portion, which is made first; and a second portion, which is made later. The first portion of the tubular enclosure is or is not structurally or otherwise distinguishable from the second portion of tubular enclosure. The mount surface in S20 is provided by a panel separable from the linear array of LED devices. The panel is made of suitable solid materials such as glass or metal. In other embodiments, the panel further includes a side wall for containing and sometimes shaping the tubular enclosure on the panel especially when, for example, pre-curing liquid polymer is involved during manufacturing. S24 includes the following steps:

S240: Dispense a fist strip of transparent polymer over the linear array of LED devices;

S242: Reverse the linear array of LED devices on the panel; and

S244: Dispense a second strip of transparent polymer over the linear array of LED devices.

In S240, the first strip of liquid polymer is dispensed over the linear array of LED devices to form the first portion of the tubular enclosure. Surface tension, which at the size of an LED device is large in relation to gravitational forces, in combination with viscosity allows the strip of liquid polymer to conformally cover all corners of the linear array of LED devices, including the gaps between the LED devices. It is desirable to do a fast cure, such as a UV cure, because the normal drop in viscosity during a thermal cure would cause most liquid polymers to flow away from the linear array of LED devices. In S242, the linear array of LED devices, which is now at least partially enclosed by the first portion of the tubular enclosure, can be flipped over on the panel and remain unharmed without additional steps when the linear array of LED devices is not adhesively attached to the panel in S20. In some embodiments, the linear array of LED devices is adhesively attached on the panel with adhesive materials such as photoresist for semiconductor fabrication and die bond glue. The linear array of LED devices can be separated from the panel after dissolving the adhesive material with proper solvents such as acetone. Residuals of adhesive material remaining on the linear array of LED devices are flushed away before moving to S244. In S244, like in S240, the second strip of liquid polymer is dispensed over the linear array of LED devices, which has been enclosed, at least partially, by the first portion of the tubular enclosure. The second strip of liquid polymer is then cured and forms the second portion of tubular enclosure. There is now an LED filament comprising the linear array of LED devices disposed in the tubular enclosure operable to emit light when energized through the electrical connector.

In another embodiment, the tubular enclosure is made from, for example, cured transparent polymer. However, the mount surface in S20 for the linear array of LED device and the electrical connector is provided by a strip of cured transparent polymer that will form a first portion of the tubular enclosure. S20 includes the following steps:

S200: Dispense a first strip of transparent polymer on a panel; and

S202: Arrange a linear array of LED devices spaced apart from one another and an electrical connector on the first strip of transparent polymer.

In the embodiment, S24 includes the following step:
S244: Dispense a second strip of transparent polymer over the linear array of LED devices.

In S200, the first strip of liquid polymer is dispensed on a panel. The first strip of liquid polymer is then cured on the panel to form the first portion of the tubular enclosure. The mount surface in S20 is provided by the first strip of cured polymer separable from the panel. The first portion of the tubular forms a surface capable of supporting the linear array of LED devices and the electrical connector throughout the steps of the method. The first strip of liquid polymer is then cured on the panel to form the first portion of the tubular enclosure. The mount surface in S20 is provided by the first strip of cured polymer separable from the panel. The panel is made of suitable solid materials such as glass or metal. In other embodiments, the panel further includes a side wall for containing and sometimes shaping the tubular enclosure on the panel especially when, for example, pre-curing liquid polymer is involved during manufacturing. In S202, to strengthen the combination when the linear array of LED devices and the electrical connector are disposed on the first portion of the tubular enclosure, optionally, an upper surface of the first portion of the tubular enclosure is melted. The linear array of LED devices and the electrical connector are then at least partially immersed into the first portion of the tubular enclosure before the upper surface cools down. In S244, like in S200, the second strip of liquid polymer is dispensed over the linear array of LED devices, which has been disposed on or at least partially enclosed by the first portion of the tubular enclosure. The second drop of liquid polymer is then cured and forms the second portion of tubular enclosure. The linear array of LED devices, which is now enclosed by the unitary structure of the first portion of the tubular and the second portion of the tubular enclosure, can be taken away from the panel and remain unharmed without additional steps when the first portion of the tubular enclosure is not adhesively attached to the panel. In some embodiments, the first portion of tubular enclosure is adhesively attached to the panel with adhesive materials such as photoresist for semiconductor fabrication and die bond glue. The first portion of tubular enclosure can be separated from the panel after dissolving the adhesive material with proper solvents such as acetone. Residuals of adhesive material remaining on first portion of the tubular enclosure are flushed away. There is now an LED filament comprising the linear array of LED devices disposed in the tubular enclosure operable to emit light when energized through the electrical connector.

In some embodiments, the first portion of the tubular in S200 is configured to be capable of withstanding potential destructions resulting from manufacturing procedures such as wire bonding. In some embodiments, the first portion of the tubular includes a hardener. For example, the hardener includes a pre-determined concentration of particles harder than the liquid polymer in which the particles are embedded. Light conversion particles such as phosphor particles are harder than the binder materials such as silicone and resin. Thus, the first portion of the tubular can be made harder by increasing the concentration of the light conversion particles in the transparent binder. In an embodiment, the first portion of tubular enclosure is configured to have a Shore hardness from D40 to D60 when the ratio of the volume of the light conversion particles in the first portion of the tubular enclosure to the volume of the transparent binder in the first portion of the tubular enclosure from 0.1 to 0.2. Alternatively, the ratio of the weight of the light conversion particles in the first portion of the tubular enclosure to the weight of the transparent binder in the first portion of the tubular enclosure is from 0.1 to 0.2. In other embodiments, the first portion of the tubular enclosure is thickened such that the thickness enable the first portion of the tubular enclosure to withstand potential destructions resulting from manufacturing procedures such as wire bonding. Preferably, the thickness of the first portion of the tubular enclosure is from 0.5 to 3 mm. Most preferably, the thickness of the first portion of the tubular enclosure is from 1 to 2 mm.

In another embodiment, the tubular enclosure is made from, for example, cured transparent polymer. However, the mount surface in S20 for the linear array of LED device and the electrical connector is provided by a strip of cured transparent polymer that will form a first portion of the tubular enclosure. S20 includes the following steps:

> S200: Dispense a first strip of transparent polymer on a panel; and
>
> S202: Arrange a linear array of LED devices spaced apart from one another and an electrical connector on the first strip of transparent polymer.

In the embodiment, S24 includes the following step:
S244: Dispense a second strip of transparent polymer over the linear array of LED devices.
In S200, the first strip of liquid polymer is dispensed on a panel. The panel is made of suitable solid materials such as glass or metal. In other embodiments, the panel further includes a side wall for containing and sometimes shaping the tubular enclosure on the panel especially when, for example, pre-curing liquid polymer is involved during manufacturing. The first strip of liquid polymer is then cured on the panel to form the first portion of the tubular enclosure. The mount surface in S20 is provided by the first strip of cured polymer separable from the panel. The first portion of the tubular enclosure forms a surface capable of supporting the linear array of LED devices and the electrical connector throughout the steps of the method. In S202, to strengthen the combination when the linear array of LED devices and the electrical connector are disposed on the first portion of the tubular enclosure, optionally, an upper surface of the first portion of the tubular enclosure is melted. The linear array of LED devices and the electrical connector are then at least partially immersed into the first portion of the tubular enclosure before the upper surface cools down. In S244, like in S200, the second strip of liquid polymer is dispensed over the linear array of LED devices, which has been disposed on or at least partially enclosed by the first portion of the tubular enclosure. The second strip of liquid polymer is then cured and forms the second portion of tubular enclosure. The linear array of LED devices, which is now enclosed by the unitary structure of the first portion of the tubular and the second portion of the tubular enclosure, can be taken away from the panel and remain unharmed without additional steps when the first portion of the tubular enclosure is not adhesively attached to the panel. In some embodiments, the first portion of tubular enclosure is adhesively attached to the panel with adhesive materials such as photoresist for semiconductor fabrication and die bond glue. The first portion of tubular enclosure can be separated from the panel after dissolving the adhesive material with proper solvents such as acetone. Residuals of adhesive material remaining on first portion of the tubular enclosure are flushed away. There is now an LED filament comprising the linear array of LED devices disposed in the tubular enclosure operable to emit light when energized through the electrical connector.

In yet another embodiment, the tubular enclosure is made from, for example, cured transparent polymer. However, the mount surface in S20 for the linear array of LED device and the electrical connector is provided by a strip of cured transparent polymer that will form a first portion of the tubular enclosure. S20 includes the following steps:

> S210: Dispense a first strip of transparent polymer on a panel;
>
> S212: Dispose a strip of FPC film on the first strip of transparent polymer; and
>
> S214: Arrange a linear array of LED devices spaced apart from one another and an electrical connector on the strip of FPC film.

In the embodiment, S24 includes the following step:
S244: Dispense a second strip of transparent polymer over the linear array of LED devices.
In S210, the first strip of liquid polymer is dispensed on a panel. The panel is made of suitable solid materials such as glass or metal. In other embodiments, the panel further includes a side wall for containing and sometimes shaping the tubular enclosure on the panel especially when, for example, pre-curing liquid polymer is involved during manufacturing. The first strip of liquid polymer is then cured on the panel to form the first portion of the tubular enclosure. The mount surface in S20 is provided by the first strip of cured polymer separable from the panel. The first portion of the tubular enclosure forms a surface capable of supporting the linear array of LED devices and the electrical connector throughout the steps of the method. In S212, to strengthen the combination when the strip of FPC film is disposed on the first portion of the tubular enclosure, optionally, an upper surface of the first portion of the tubular enclosure is melted. The strip of FPC film is then at least partially immersed into the first portion of the tubular enclosure before the upper surface cools down. In some embodiments, the strip of PFC film includes a linear array of apertures punched by, for example, a stamping press. Optionally, the aperture is dimensionally smaller than the LED device. In these embodiments, each of the linear array of LED devices straddles exactly one of the linear array of apertures. Light coming from the linear array of LED devices will not be blocked by the strip of FPC film. In S22, a combination of wire bonding and FPC is employed to electrically and connect the linear array of LED devices. The bonding wire is attached to a conductive track of the strip of FPC film on a first end and attached to an ohmic contact of an LED device on a second end. In S244, like in S210, the second strip of liquid polymer is dispensed over the linear array of LED devices, which has been disposed on or at least partially enclosed by the first portion of the tubular enclosure. The second strip of liquid polymer is then cured and forms the second portion of tubular enclosure. The linear array of LED devices, which is now enclosed by the unitary structure of the first portion of the tubular and the second portion of the tubular enclosure, can be taken away from the panel and remain unharmed without additional steps when the first portion of the tubular enclosure is not adhesively attached to the panel. In some embodiments, the first portion of tubular enclosure is adhesively attached to the panel with adhesive materials such as photoresist for semiconductor fabrication and die bond glue. The first portion of tubular enclosure can be separated from the panel after dissolving the adhesive material with proper solvents such as acetone. Residuals of adhesive material remaining on first portion of the tubular enclosure are flushed away. There is now an LED filament comprising the linear array of LED devices disposed in the tubular enclosure operable to emit light when energized through the electrical connector.

The line L-L cuts the LED filament radially right along a lateral surface of the LED device. Likewise, the line M-M cuts the LED filament radially right along the other lateral surface of the LED device. The tubular enclosure is a tubular structure having exactly one layer or a plurality of distinct layers. The tubular enclosure has exactly one layer over the LED device. In the embodiment, the tubular enclosure is a multi-layered structure over the LED device. Each layer of the tubular enclosure is configured to add a distinctive function to the LED filament. For example, the tubular enclosure includes three layers.

In an embodiment, the LED device has a textured light emission surface to increase light extraction from the diode layer by reducing total internal reflection. The light emission surface includes the surface of the diode layer D, the surface of the substrate S or both. The light emission surface is treated with subtractive processes such as etching, cutting and grinding wherein material is removed from the light emission surface to create the desired texture.

In an embodiment, the tubular enclosure includes a wavelength conversion layer. The wavelength conversion layer includes a transparent binder in which a plurality of light conversion particles, such as phosphor particles, are embedded. The phosphor particles may be formed from any suitable phosphor capable of converting light of one wavelength into another wavelength. Cerium(III)-doped YAG is often used for absorbing the light from the blue LED device and emits in a broad range from greenish to reddish, with most of output in yellow. This yellow emission combined with the remaining blue emission gives the white light, which can be adjusted to color temperature as warm (yellowish) or cold (blueish) white. The pale yellow emission of the Ce3+:YAG can be tuned by substituting the cerium with other rare earth elements such as terbium and gadolinium and can even be further adjusted by substituting some or all of the aluminium in the YAG with gallium. Alternatively, some rare-earth doped Sialons are photoluminescent and can serve as phosphors. Europium(II)-doped β-SiAlON absorbs in ultraviolet and visible light spectrum and emits intense broadband visible emission. Its luminance and color does not change significantly with temperature, due to the temperature-stable crystal structure. Thus, it is suitable for using as green down-conversion phosphor for white-light LED filaments; a yellow variant is also available. To generate white light, a blue LED device is used with a yellow phosphor, or with a green and yellow SiAlON phosphor and a red CaAlSiN3-based (CASN) phosphor. In an embodiment, the wavelength conversion layer is configured to convert light emitting from the LED device into light having a color temperature from 2400 to 2600 K by, for example, embedding in the transparent binder an appropriate combination of yellow-and-green phosphor and red phosphor.

The amount of light absorbed and re-emitted by the light conversion particles is generally proportional to the amount of light conversion particles that the light passes through before egressing the LED filament. However, if the light passes through too much light conversion particles, part of the re-emitted light can be blocked from emitting from the LED filament, by the excess light conversion particles. This reduces the overall light emitting efficiency of the LED filament. The amount of light conversion particles that the LED light passes through can be varied by varying the concentration of light conversion particles, the thickness of the wavelength conversion layer, or both. In an embodiment, light from the linear array of LED devices passes through a sufficient amount of light conversion particles so that substantially all of the light is absorbed and re-emitted at a different wavelength of light. At the same time, the re-emitted light does not pass through an excess light conversion material so that the re-emitted light is not blocked from emitting from LED filament. By providing a sufficient amount of light conversion particles to provide full conversion without blocking, the light conversion particles are in state of optimal conversion. The amount of light conversion particles for optimal conversion depends on the size and luminous flux of the LED filament. The greater the size and luminous flux, the greater the amount of light conversion particles needed. Under optimal conversion, the light emitted from the LED filament is composed primarily of photons produced by the light conversion particles. Preferably, the ratio of the volume of the light conversion particles in the wavelength conversion layer to the volume of the transparent binder in the wavelength conversion layer is from 0.1 to 0.2. Preferably, the ratio of the weight of the light conversion particles in the wavelength conversion layer to the weight of the transparent binder in the wavelength conversion layer is from 0.1 to 0.2. In some embodiments, however, it may be desirable to allow a small portion of the light to be transmitted through the light conversion particles without absorption for purposes of modifying the chromaticity of the resulting radiation of the LED filament. For example, the LED filament emits less than 10% of the emission power of primary radiation in the absence of the light conversion material particles. In other words, the conversion particles absorb 90% or more of the light from the linear array of LED devices.

Suitable materials for the transparent binder include silicone, resin and epoxy. However, these materials, having a thermal conductivity from 0.1 to 0.2 W/(m·K), are poor thermal conductors in relation to the light conversion particles 406 like phosphor, which has a thermal conductivity of 0.1W/(mK). Excess heat trapped inside the wavelength conversion layer compromises the performance of the heat-sensitive LED devices. Moreover, the transparent binder, when bathed in excess heat, becomes brittle and unpleasantly yellow over time. Thus, it is desirable to configure the wavelength conversion layer in a way heat is efficiently transferred away from the LED device from the wavelength conversion layer. In an embodiment, the wavelength conversion layer includes a plurality of heat transfer paths extending in a substantially radial direction for transferring heat away from the LED device and the wavelength conversion layer. The concentration of light conversion particles in the transparent binder is so low that the heat transfer paths are mostly broken because the majority of the light conversion particles, sealed by the transparent binder, are far apart from one another. By contrast, the concentration of the light conversion particles is high enough for the light conversion particles to form a plurality of heat transfer paths by lining up the light conversion particles successively along a substantially radial direction because the majority of the light conversion particles, not being completely sealed by the transparent binder, are at least partially in direct contact with neighboring light conversion particles 406 on a same light transfer path 1002. Preferably, the ratio of the volume of the light conversion particles in the wavelength conversion layer to the volume of the transparent binder in the wavelength conversion layer is from 0.1 to 0.2. Preferably, the ratio of the weight of the light conversion particles in the wavelength conversion layer to the weight of the transparent binder in the wavelength conversion layer is from 0.1 to 0.2. As previously discussed, if the light passes through too much light conversion particles, part of the re-emitted light can be blocked from emitting from the wavelength conversion layer by the excess light conversion particles. By providing a sufficient concentration of light conversion particles for sufficient heat transfer paths without blocking, the light conversion particles are in state of thermal optimum. Preferably, under the thermal optimum, the ratio of the volume of the light conversion particles in the wavelength conversion layer to the volume of the transparent binder in the wavelength conversion layer is from 0.1 to 0.2. Preferably, the ratio of the weight of the light conversion particles 406 in the wavelength conversion layer to the weight of the transparent binder in the wavelength conversion layer is from 0.1 to 0.2. Given the same concentration, the plurality of heat transfer paths that otherwise would not exist if the light conversion particles are evenly dispersed throughout the transparent binder can be formed by maneuvering the distribution of the light conversion particles in the transparent binder where the plurality of heat transfer paths are planned. The concentration of the light conversion particles is comparable to the concentration of the light conversion particles. As previously stated, the heat transfer paths are mostly broken. By contrast, the wavelength conversion layer includes the plurality of heat transfer paths similar in shape to a spoke having the LED device as a hub. The concentration of the light conversion particles along the planned paths is high enough for the light conversion particles to form a plurality of heat transfer paths, e.g. like a spoke, by lining up the light conversion particles successively along a substantially radial direction because the majority of the light conversion particles are at least partially in direct contact with neighboring light conversion particles in the que. The heat transfer path passes through the wavelength conversion layer in which the concentration of the light conversion particles is appreciably lower than the concentration of the light conversion particles that lays out the heat transfer path. By elevating the concentration of the light conversion particles only where the heat transfer path is planned in the transparent binder, the heat transfer paths can be obtained while mitigating the problem of light blocking resulting from excessive concentration of the light conversion particles. In some embodiments, the heat transfer path further includes a gap filler for tightening up the contact between the light conversion particles on the heat transfer path. For example, the heat transfer path further includes a plurality of nanoparticles such as TiO2, Al2O3, SiO3, ZrO2, CaO, SrO, BaO, diamond, silicon carbide, silicon nanoparticles. These nanoparticles, having a thermal conductivity from 0.1 to 0.2 W/(m·K), are dimensionally much smaller than the light conversion particles that constitute the primary ingredient of the heat transfer path. For example, the nanoparticle is from 10 to 300 nm. Preferably, the nanoparticle is from 20 to 100 nm. The nanoparticles help close the gaps between the light conversion particles on the heat transfer path. Other things equal, the heat transfer path, when further including nanoparticles, becomes a more efficient heat conduit because the light conversion particles on the heat transfer path are in a tighter contact with one another than in the absence of nanoparticles.

Soft materials such as silicone and resin are suitable materials for the transparent binder. A bendable LED filament is made possible with these highly elastoplastic materials. However, sometimes it is desirable to use these inherently soft materials to provide a LED filament capable of self-sustained plastic deformation such that external support structures can be minimized or even eliminated when the LED filament is expected to maintain a particular posture when it is connected to a lighting fixture such as LED light bulb. The posture could be a straight line extending vertically, horizontally or in any other direction. The posture could be curves of any kind, including simple curves such as arc and polygon and complex curves such as helix, petal and gift ribbon. In an embodiment, the wavelength conversion layer includes a posture maintainer such that the LED filament is capable of self-sustained plastic deformation. For example, the posture maintainer includes a pre-determined concentration of particles harder than the transparent binder in which the particles are embedded. Alternatively, the posture maintainer includes a wire system embedded in the transparent binder. Moreover, the posture maintainer includes an aperture system embedded in the transparent binder. Light conversion particles such as phosphor particles are harder than the binder materials such as silicone and resin. Thus, the wavelength conversion layer can be made harder by increasing the concentration of the light conversion particles in the transparent binder. In an embodiment, the hardened wavelength conversion layer includes alternate coatings of the transparent binder and the phosphor particles. The wavelength conversion layer is thus configured to exhibit an even concentration of the phosphor particles throughout the wavelength conversion layer. In some embodiments, the wavelength conversion layer is configured to have a Young's modulus from $0.1 \times 10^{10}$ to $0.3 \times 10^{10}$ when the ratio of the volume of the light conversion particles in the wavelength conversion layer to the volume of the transparent binder in the wavelength conversion layer is from 0.1 to 0.2. Alternatively, the ratio of the weight of the light conversion particles in the wavelength conversion layer to the weight of the transparent binder in the wavelength conversion layer is from 0.1 to 0.2. In other embodiments to be used with LED light bulbs, the wavelength conversion layer is configured to have a Young's modulus from $0.15 \times 10^{10}$ to $0.25 \times 10^{10}$ Pa when the ratio of the volume of the light conversion particles in the wavelength conversion layer to the volume of the transparent binder in the wavelength conversion layer is from 0.1 to 0.2. Alternatively, the ratio of the weight of the light conversion particles in the wavelength conversion layer to the weight of the transparent binder in the wavelength conversion layer is from 0.2 to 0.2.

In another embodiment, the posture maintainer includes a wire system embedded in the transparent binder to reinforce the wavelength conversion layer comprising primarily elastic binder materials such as silicone or resin. The wire is made from resilient materials such as copper and glass fiber and preferably light transmissive materials such as nanotubes. The wire system comes in many structures of 2-D or 3-D depending on the application. The wire system includes a simple set of straight wires extending longitudinally in the wavelength conversion layer. The wire system includes a set of sinuous springs extending longitudinally in the wavelength conversion layer. The wire system includes a helical spring extending longitudinally in the wavelength conversion layer. The wire system includes a grid structure extending in the wavelength conversion layer along the longitudinally axis of the LED filament. The wire system includes a rectilinear grid extending in the wavelength conversion layer along the longitudinally axis of the LED filament. The wire system includes a curvilinear grid extending in the wavelength conversion layer along the longitudinally axis of the LED filament.

In yet another embodiment, the posture maintainer includes an aperture system on the surface of the wavelength conversion layer where tight turns are planned for the posture the LED filament is expected to maintain in an application. For example, the LED filament is expected to maintain an S-shaped posture. A set of apertures is deployed at the inner part of the wavelength conversion layer where the tight turn is planned. The set of apertures makes it easier for the LED filament to maintain the S-shaped posture by accommodating compression at the inner part of the tight turn. In some embodiments, the wire system includes a combination of the structures illustrated above. For example, the wire system includes a combination of straight wire, helical spring and aperture system. The helical spring is deployed in the wire system only where the tight turns are planned for the posture the LED filament is expected to maintain in an application. Otherwise, only the straight line is deployed. A set of apertures is deployed at the inner part of the wavelength conversion layer where the tight turn is planned.

In an embodiment, the outer surface of the tubular enclosure is provided by a polished layer. An LED filament having a glossy finish may be aesthetically appealing to some people. However, the LED filament may suffer from total internal reflection or poor heat dissipation. In another embodiment, the outer surface of the tubular enclosure is provided by a texturized layer. The texturized layer improves light extraction by reducing total internal reflection. The texturized layer enhances heat dissipation by providing the tubular enclosure with a greater surface area than a polished layer does. For example, the textured layer is formed by a sufficient concentration of the light conversion particles found close to but bulging from the outer surface of the wavelength conversion layer. By contrast, the tubular enclosure includes a dedicated texturized layer having different patterns such as wedge and cube.

Yttrium aluminum garnet (YAG), typically having a refractive index (RI) of about 1.8, is an example of a common phosphor that may be used. The RI of the phosphor particles and the RI of the binder material can be the same or different. In an embodiment, the binder material includes a transparent material having an RI that is substantially matched to that of the wavelength conversion particles embedded therein. For example, the binder material includes a high-index silicone having an RI of about 1.6 or greater. By providing the wavelength conversion particles in a substantially index-matched binder material, light scattering losses due to differences in the RI of the binder material and the wavelength conversion particles can be reduced or eliminated.

In some embodiments, a plurality of nanoparticles 408 is embedded in the transparent binder 404 that formed the wavelength conversion layer 402. The nanoparticles 408 are dispersed throughout the transparent binder 404 of the wavelength conversion layer 404. By including nanoparticles with a RI higher than that of the host medium-the transparent binder-the effective RI of the host medium is increased. The presence of nanoparticles in the transparent binder brings the RI of the transparent binder (e.g., regular silicone with an RI of about 1.5) closer to the RI of the phosphor particles (with an RI of about 1.8). When these two elements are not closely index-matched, the difference in RI results in light scattering because typical phosphor particles are substantially larger (about 5.5 $\mu$m) than the wavelength of light emitted from the LED device (450 nm for a blue LED). Light extraction efficiency increases when the difference in RI between the phosphor particle and the transparent binder is reduced. However, the efficiency only increases up to a point. If the effective RI of the transparent binder gets too high, the light extraction efficiency will decrease due to total internal reflection at the flat interface of the wavelength conversion layer and any surrounding medium having a lower RI (e.g., silicone or air). An acceptable effective RI for the wavelength conversion layer is approximately 1.7, providing optimal index-matching with manageable levels of total internal reflection. The nanoparticles may comprise several different materials such as $TiO_2$, $Al_2O_3$, $SiO_3$, $ZrO_2$, CaO, SrO, BaO, diamond, silicon carbide, silicon nanoparticles. The RI of both $TiO_2$ and diamond is approximately 2.5. The volume of nanoparticles that is needed to adjust the effective RI of the wavelength conversion layer by a certain amount can be easily calculated using Vegard's Law which states that the relationship between volume and RI is linear. For example, if the wavelength conversion layer material has a RI of 1.5 and the target effective RI is 1.7, then the wavelength conversion layer should comprise approximately 20% $TiO_2$ nanoparticles by volume. Other material combinations and compositions may also be used. For example, some embodiments may have greater than 5% nanoparticles by volume. Other embodiments may have greater than 10% nanoparticles by volume. Still other embodiments may include 20-40% by volume. The concentration of the nanoparticles depends on such factors as the material being used and the desired RI adjustment.

Sometimes it is desirable to load the wavelength conversion layer with a high volume of light conversion particles. There would be less space in the wavelength conversion layer for nanoparticles. As discussed above, the nanoparticles are used to adjust the effective RI of the wavelength conversion layer. When the nanoparticles do not produce a large enough RI shift in the wavelength conversion layer, the space layer can compensate for those cases. In addition to shifting RI, the spacer layer, when interposed between the LED device and the wavelength conversion layer, enables a uniform thickness of the wavelength conversion layer to produce uniform white light, which entails a proper combination of blue light and the phosphor light. However, a variety of factors cause the thickness of the wavelength conversion layer to be uneven when it is disposed directly over the LED device. The surface of the LED device might be, intentionally or unintentionally, uneven. For example, the wavelength conversion layer would be thinner at the point than at the point when the surface of the LED device is texturized. Moreover, the array of LED devices does not define a perfectly even interface for the wavelength conversion layer to sit on. For example, the wavelength conversion layer would be thinner at the point than at the point. Where the wavelength conversion layer is relatively thin, blue light would dominate because there would be insufficient contribution of light from the phosphors. The spacer layer eliminates the problem by forming a level interface for the wavelength conversion layer to sit on. The spacer layer can be made of many different materials such as silicone, epoxy, oil, dielectrics, and other materials. The material should be chosen such that the RI of the spacer layer is smaller than the RI of the LED device and the RI of the wave length conversion layer. A portion of the light that enters the spacer layer is then incident on the interface between the spacer layer and the wavelength conversion layer. At the interface the light sees a step-up in RI and passes into wavelength the conversion layer with minimal reflection. If the light is reflected or backscattered in the wavelength conversion layer, it will see the RI step-down at the spacer layer interface and has a finite chance of being reflected back into the wavelength conversion layer because of the TIR phenomenon.

Index-matching the transparent binder with the phosphor particles reduces scattering within the wavelength conversion layer. However, such reduction in scattering adversely affects the uniformity of the color temperature distribution in the LED filament. To mitigate the negative effect, light scattering particles (LSPs) are disposed proximate to the LED device. The LSPs are distributed around the LED device so that the individual photons are redirected before they are emitted to randomize the point where they exit the device. This has the effect of evening out the color temperature distribution such that an outside observer sees roughly the same color over a broad range of viewing angles. The LSPs should have a high RI relative to the surrounding medium, creating a large RI differential between the materials. Because the RI differential causes refraction, it would also be possible to use an LSP material that has a low RI relative to the surrounding medium. The LSPs create localized non-uniformities in the medium that force the light to deviate from a straight path. When the light strikes one or more of the scattering particles the RI differential between the medium and the particles causes the light to refract and travel in a different direction. A large RI differential yields a more drastic direction change for an incident photon. For this reason, materials with a high RI work well in mediums such as silicone or epoxy. Another consideration when choosing a light scattering material is the optical absorbance of the material. Large particles backscatter more of the light inside the package before it can escape the device, decreasing the total luminous output of the device. Thus, preferred scattering particle materials have a high RI relative to the medium and a particle size comparable to the wavelength of the light propagating through the host medium. Ideally, LSPs ensure maximum forward or sideways scattering effect for a given spectrum while minimizing light loss due to backscattering and absorption. The LSPs can comprise many different materials, e.g., silica gel, silicon nanoparticles and zinc oxide (ZnO). Various combinations of materials or combinations of different forms of the same material may be used to achieve a desired scattering effect. Various percentages of composition of the LSPs can be used as dictated by the application. Depending on the materials used, the LSPs will typically be found in concentrations ranging from 0.01% to 5% by volume. Other concentrations can be used; however, the loss due to absorption increases with the concentration of the scattering particles. Thus, the concentrations of the LSPs should be chosen to maintain an acceptable loss figure. In some embodiments, the light scattering particles have diameters that range from 0.1 $\mu$m to 2 $\mu$m. In some cases, it may be desirable to use LSPs of different sizes. For example, in one embodiment a first plurality of LSPs may comprise titania, silica and diamond, and a second plurality of LSPs may comprise fused silica, titania and diamond. Many other combinations are possible to achieve a desired color temperature distribution.

The LSPs can be dispersed anywhere in the LED filament so long as they are proximate to the LED device such that substantially all of the emitted light has a good probability of interacting with the LSPs. The LSPs are dispersed in the wavelength conversion layer throughout the binder material along with the nanoparticles and the phosphor particles. Because the wavelength conversion layer is disposed on the LED device, substantially all of the light travels through the wavelength conversion layer where the LSPs are dispersed before egressing the LED filament. In other embodiments, the LSPs are dispersed throughout a binder material in a dedicated light scattering layer disposed over the LED device. The wavelength conversion layer is sandwiched by the light scattering layer and LED device. The LSPs are dispersed in the light scattering layer throughout the binder material. Because the light scattering layer is disposed all over the LED device, all of the light, converted by wavelength conversion layer, must subsequently travel through the light scattering layer before egressing the LED filament.

In an embodiment, the LED light bulb comprises a light transmissive envelope, a base, a stem press, an LED filament and a plurality of lead wires. The light transmissive envelope is a bulbous shell made from light transmissive materials such as glass and plastic. The light transmissive envelope includes a bulbous main chamber for housing the LED filament and sometimes a neck dimensionally adapted for attaching to the base. At least part of the base is metal and includes a plurality of electrical contacts for receiving electrical power from a lampholder. The light transmissive envelope is mounted with its neck on the base. The stem press is mounted on the base within the light transmissive envelope for holding the lead wire and the LED filament in position while keeping the positive and negative currents insulated from each other. The lead wire extends in a substantially axial direction from the base through the neck all the way into the main chamber. The lead wire physically and electrically connects the electrical contact of the base and an electrical connector of the LED filament. Electrical power is communicated from the lampholder to the base and all the way to the LED filament through the lead wire when the base and the lampholder are properly connected. The LED light bulb is thus configured to emit light omnidirectionally. In some embodiments, the LED light bulb, including exactly one LED filament, is configured to emit light omnidirectionally. In other embodiments, the LED light bulb, including a plurality of LED filaments, is configured to emit light omnidirectionally. In addition to brining electrical power for the LED filament, the lead wire also supports the LED filament to main a desired posture in the main chamber.

In some embodiment where the lead wires alone do not provide sufficient support, the LED light bulb further includes a plurality of support wires to help the LED filament maintain a desired posture in the main chamber. In some embodiments, the support wire is made of carbon spring steel for additional damping protection. Preferably, the support wire is not in electrical communication with any part of the LED light bulb. Thus, negative impacts resulting from thermal expansion or heat are mitigated. When the LED filament defines a sinuous curve in the main chamber, the lead wire supports the LED filament either at the crest of the curve, the trough of the curve or anywhere between the crest and the trough. The support wire attaches to the LED filament in a variety of ways. For example, the lead wire includes a hook or claw at a tip. The throat of the hook is snugly closed around the LED filament. Alternatively, the claw is snugly closed around the LED filament.

In an embodiment, the LED light bulb include exactly two lead wires. The base includes a top end, a bottom end and a side surface. the light transmissive envelope is mounted with its neck on the top end of the base. The base includes a foot electrical contract at the bottom end and a base electrical contact on the side surface. A first lead wire physically and electrically connects the foot electrical contact and a first electrical connector of the LED filament. A second lead wire physically and electrically connects the base electrical contact and a second electrical connector of the LED filament. For example, the lead wire and the electrical contact is fastened together by soldering. The filler metal includes gold, silver, silver-based alloy or tin. Alternatively, when the electrical connector includes an aperture and the lead wire includes a hook structure at a tip, the lead wire and the electrical connector is fastened by closing the throat of the hook against the aperture. In some embodiments, the LED light bulb further includes a rectifier, which is in electrical connection with the electrical contact of the base and the lead wire, for converting AC electricity from the lampholder into DC electricity to drive the LED filament.

Preferably, the base has a form factor compatible with industry standard light bulb lampholder. Specifications for light bulb bases and sockets largely overseen by two organizations. The American National Standards Institute (ANSI) is an organization that publishes C81.61 and C81.62, while International Electrotechnical Commission (IEC) publishes 60061-1 and 60061-2. Edison screw lamp base and lampholder examples include but are not limited to the E-series described in ANSI C81.61 and C81.62: E5 midget, E10 miniature, E11 mini-candelabra, E12 candelabra, E17 intermediate, E26/24 single-contact medium, E26d double-contact medium, E26/50x39 skirted medium, E26/53x39 extended skirted medium, E29/53x39 extended skirted admedium, E39 single-contact mogul, E39d double-contact mogul, EP39 position-oriented mogul, and EX39 exclusionary mogul. Multiple-pin lamp base and lampholder examples include but are not limited to the G-series described in ANSI C81.61 and C81.62: GY two-pin for T, G4 two-pin for single-ended TH, GU4 two-pin for MR11 GLS lamps, GZ4 two-pin for projection lamps, G5 fluorescent miniature two-pin, 2G7 four-pin compact fluorescent, GZ10 bipin, G16t three-contact lug for PAR lamps, G17t three-pin prefocus for incandescent projection lamps. Bayonet lamp base and lampholder examples include but are not limited to the B-series described in ANSI C81.61 and C81.62: B/BX8.4d small instrument panel, BA9/12.5 miniature, BAW9s for HY21W, BA15s candelabra single contact, BAZ15d double contact with offset, and BY22d multipurpose sleeved double contact.

In an embodiment, the light transmissive envelope is made from a light transmissive material with good thermal conductively. In another embodiment, the light transmissive envelope is configured to absorb a portion of the blue light emitted by the LED filament to obtain a warmer color temperature. To make the light warmer, for example, the light transmissive envelope is made from a material doped with yellow particles. Alternatively, the light transmissive envelope is coated with a yellow film. In yet another embodiment, the light transmissive envelope, which is hermetically connected to the base, is charged with a gas having greater thermal conductivity than the air such as hydrogen, nitrogen and a mixture of both. In additional to greater heat dissipation, humidity, potentially undermining the electronics of the light bulb, is thus removed from the light transmissive envelope. In an embodiment, hydrogen accounts for from 5 to 50% of the volume of the light transmissive envelope. In still another embodiment, the light transmissive envelope is sealed at an internal pressure of from 0.4 to 1.0 ATM.

The stem press is made from an electrically insulative material such as glass or plastic. The shape and dimension of the stem press depends a totality of considerations such as the number of LED filaments the LED light bulb has, the posture the LED filament is expected to maintain in the main chamber; the manner the lead wire supports the LED filament; the number of lead wires the LED light bulb has; whether the LED light bulb further includes support wires; and whether or how a heatsink finds itself in the LED light bulb. In an embodiment, the stem press extends barely above the base. In another embodiment, the stem press extends above the base and into the neck. In yet another embodiment, the stem extends above the base, through the neck and into the chamber. In some embodiments, the stem press is made from an electrically insulative material have good thermal conductivity such as aluminium oxide and aluminium nitride. In other embodiments, the stem press includes an opening for evacuating the air from the light transmissive envelope and for charging the light transmissive envelope with the desired amount of gas.

In some embodiments, the LED light bulb further includes a heatsink. The heatsink is made from materials have good thermal conductivity such as metal, thermal ceramics and thermal plastic. In some embodiments, the stem press, the base or both is made from a same material from which the heatsink is made. In other embodiments, an integral piece including a combination of at least two of the stem press, the base and the heat sink is formed with a same material to reduce the thermal resistance of the LED light bulb. The heatsink is in thermal communication with the LED filament and ambient air for transferring heat coming from the LED device to the ambient air. Preferably, the heatsink is in thermal communication with, in addition to the LED filament and ambient air, the stem press, the lead wire, the support wire, the base or any combination of the above.

The LED filament is designed to maintain a posture within the chamber to obtain an omnidirectional light emission. The LED light bulb comprises a light transmissive envelope, a base, a stem press, exactly one LED filament, exactly a pair of lead wires, a heatsink and a rectifier. The heatsink is disposed between the light transmissive envelope and the base. The rectifier is disposed within the heatsink. The stem press includes a stump-like structure projecting from the base. The LED filament defines an arc extending substantially vertically in the light transmissive envelope. For easy reference, a Cartesian coordinate system is oriented for the LED light bulb where: (1) the interface connecting the light transmissive envelope and heatsink falls on the x-y plane; and (2) the z-axis, also the central axis of the LED light bulb, intersects the interface at point O. In the embodiment, the end point of the arc reaches as high as point H1 on the y-axis. The distance between the end points of the LED filament on the x-y plane is D. The length of LED filament on the y-axis is A. The posture of the LED filament in the LED light bulb is defined by all points in the set (0, y, z+H1), where z goes up from 0 to A and then from A back to 0 as y goes from -D/2 to 0 and then from 0 to D/2. The length of the heatsink along the z-axis is L1. The length of the combination of the light transmissive envelope and the heatsink along the z-axis is L2. The greater the ratio L1/L2 is, the LED light bulb is configured to have a better heat dissipation but potentially compromised filed of angle when the LED filament is elevated to a higher position within the light transmissive envelope. Preferably, the ratio L1/L2 is from 1/30 to 1/3.

The LED light bulb comprises a light transmissive envelope, a base, a stem press, exactly one LED filament, exactly a pair of lead wires, a heatsink, a rectifier and a plurality of support wires. The heatsink is disposed between the light transmissive envelope and the base. The rectifier is disposed within the heatsink. The stem press, unlike the one in Fig. 12A, further includes a post portion for elevating the LED filament to a desired position in the light transmissive envelope. The plurality of support wires radiate (horizontally, for example) from the post portion to form a spoke-and-hub structure in the light transmissive envelope. The support wire is attached to the post portion at a first end and to the LED filament at a second end. In the embodiment, the LED filament defines a sinuous curve along an arc meandering substantially horizontally in the light transmissive envelope. The sinuous curve oscillates in the range from H1+A1 to H1-A1 on the y-axis, where H1 represents the average height of the LED filament in the LED light bulb and A1 the amplitude of the sinuous curve the LED filament defines. The plurality of support wires have a same length R. The posture of the LED filament in the LED light bulb is defined by all points in the set (x, y, z + H1), where -R =< x =< R; -R =< y =< R; and -A1 =< z =< A1. The LED filament, seen through the light transmissive envelope, is aesthetically pleasing when it is glowing or not. Moreover, omnidirectional light emission is made possible with only one LED filament having a posture like this. The quality as well the cost for producing omnidirectional LED light bulbs is thus improved because fewer interconnections of parts are needed when only one LED filament is involved.

The LED light bulb comprises a light transmissive envelope, a base, a stem press, exactly one LED filament, exactly a pair of lead wires, a rectifier and a plurality of support wires. The light transmissive envelope has a bulbous main chamber for housing the LED filament and a neck for connecting the light transmissive envelope to the base. The rectifier is disposed within the base. The plurality of support wires radiate (slightly deviating from the horizon, for example) from the post portion to form a spoke-and-hub structure in the light transmissive envelope. The support wire is attached to the post portion at a first end and to the LED filament at a second end. In the embodiment, the LED filament defines a sinuous curve along an arc meandering substantially horizontally in the light transmissive envelope. The sinuous curve oscillates in the range from H2+A2 to H2-A2 on the y-axis, where H2 represents the average height of the LED filament in the LED light bulb and A2 the amplitude of the sinuous curve the LED filament defines. A2 is greater than A1; likewise, H2 is greater than H1. Consequently, the stem press in Figs. 12 A and 12B is a shorter structure projecting from projecting from the base. By contrast, the stem press in Fig. 13A is needed to elevate the LED filament to a higher position in the main chamber becomes a longer structure having, for example, a basal portion and an elongated post portion. The plurality of support wires have a same length R. The posture of the LED filament in the LED light bulb is defined by all points in the set (x, y, z + H2), where -R =< x =< R; -R =< y =< R; and -A2 =< z =< A2.

The LED light bulb comprises a light transmissive envelope, a base, a stem press, an upper LED filaments, a lower LED filament, an upper set of lead wires, a lower set of lead wire, a rectifier and exactly two sets of support wires. The light transmissive envelope has a bulbous main chamber for housing the LED filament and a neck for connecting the light transmissive envelope to the base. The rectifier is disposed within the base. The set of support wires radiate (slightly deviating from the horizon, for example) from the post portion to form a spoke-and-hub structure in the light transmissive envelope. The support wire is attached to the post portion at a first end and to the LED filament at a second end. The upper set of support wires is configured to hold the upper LED filament in position. The lower set of support wires is configured to hold the lower LED filament in position. Other things equal, a shorter LED filament is needed to produce the same luminosity of omnidirectional light with the LED light bulb in Fig. 14A than the LED light bulb in Fig. 13A. Likewise, the LED light bulb in Fig. 14A is amenable to a smaller girth than the LED light bulb in 13A. In the embodiment, the LED filament defines a sinuous curve along an arc meandering substantially horizontally in the light transmissive envelope. The higher LED filament defines a higher sinuous curve oscillating in the range from H3+A3 to H3-A3 on the y-axis, where H3 represents the average height of the higher LED filament in the LED light bulb and A3 the amplitude of the first sinuous curve the higher LED filament defines. The lower LED filament defines a lower sinuous curve oscillating in the range from H4+A3 to H4-A3 on the y-axis, where H4 represents the average height of the lower LED filament in the LED light bulb and A3 the amplitude of the lower sinuous curve the lower LED filament defines. H4 is less than H3 on the y-axis, making one LED filament higher in the light transmissive envelope than the other one. A3 is chosen to be, for example, the same as that of the higher sinuous curve. The plurality of support wires have a same length R. The posture of the higher LED filament in the LED light bulb is defined by all points in the set (x, y, z+H3), where -R =< x =< R; -R =< y =< R; and -A3 =< z =< A3. The posture of the lower LED filament in the LED light bulb is defined by all points in the set (x, y, z+H4), where -R =< x =< R; -R =< y =< R; and -A3 =< z =< A3.

In the embodiment in Fig. 14A, the rectifier, which is disposed in the base, includes a circuit board in electrical communication with the lead wire. The pair of lead wires are parallelly spaced apart from each other. The upper portion of the lead wire is attached to the pair of LED filaments. The intermediate portion of the lead wire is fixedly attached to the basal portion of the stem press by passing through the basal portion. The lower portion of the lead wire is fixedly attached to the rectifier. In an embodiment, the circuit board includes an L-shaped aperture cut into the circumference of the circuit board. The lead wire includes a hook at the tip. The hook is configured to interlock the aperture for reliable soldering between the lead wire and the circuit board. The lead wire has a proper length for connecting the circuit board and the LED filament. In an embodiment, for purposes of safety, the lead wire has a length determined by D (mm). $D = A + \sqrt{(B - 3.2)^2 + C^2}$, where 3.2 is the electricity safety spacing; A is the aggregate of the thickness of the circuit board and the length of the lead wire projecting downwards from the circuit board; B is the distance between the pair of lead wires; and C is distance from the entry point of the lead wire into the basal portion to the entry point of lead wire into the circuit board. Preferably, the length of the lead wire needs to reach the lower LED filament (L1) is from 0.5D to 2D. Most preferably, L1 is from 0.75D to 1.5D. The length of the lead wire needs to reach the upper LED filament (L2) is L1+(H3-H4).

In some embodiments, a layer of reflective materials, e.g. white paint, is coated to the support wire, the stem press, the upper surface of the base in the light transmissive envelope or any combination of the above for directing light outwards. In other embodiments, a layer of graphene, which has good thermal conductivity, is coated to the support wire, the stem press, the upper surface of the base in the light transmissive envelope or any combination of the above for better heat dissipation.

The LED filament module includes a frame and a plurality of LED filaments operably connected to the frame. The frame comes in a variety of shapes to enable the plurality of LED filaments to jointly glow omnidirectionally in the LED light bulb. In some embodiments, the frame is made of an electrically conductive material such as copper. The plurality of LED filaments, in electrically communication with the frame, receive electrical power from the frame. In other embodiments, the frame is made of an electrically insulative material such as plastic. The LED filament module further includes an electrical wire system embedded in the frame. The plurality of LED filaments, in electrically communication with the electrical wire system, receives electrical power from the electrical wire system. Preferably, the frame is made from materials having good thermal conductivity such as aluminum alloy. Preferably, the frame is made from flexible materials such as copper wire to accommodate the shape of the LED filament module. Preferably, the frame is made from light transmissive materials such as plastic. The plurality of LED filaments are electrically interconnected in series, in parallel or in a combination of both. The LED module looks like a balcony rail. The frame includes a top rail and a bottom rail defining a pair of concentric arcs. The LED filament is attached to the top rail at one end and to the bottom rail at the other end. The plurality of LED filaments, spaced apart from one another, straddle the top rail and the bottom rail. In Fig. 15C, the top rail and the bottom rail define a pair of parallel lines. The LED filament is attached to the top rail at one end and to the bottom rail at the other end. The plurality of LED filaments, pairwise parallel, straddle the top rail and the bottom rail. The frame further includes a plurality of balusters configured to spatially coincide the plurality of LED filaments throughout the frame. The baluster is attached to the top rail at one end and the bottom rail at the other end. The baluster is either electrically conductive or insulative. The plurality of balusters, spaced apart from one another, straddle the top rail and the bottom rail. While the top rail and the bottom rail are physically connected with the baluster, the baluster is not supposed to put the top rail and the bottom rail in electrical communication with each another. Insulation is obtained in a variety of ways. The entire baluster is made from or coated with an electrically insulative material. Alternatively, the interface where the baluster and the rail are joined is electrically insulative. Alternatively, the otherwise electrically conductive baluster includes an insulator. The insulator is, for example, a piece of plastic or ceramics. The insulator is air. The plurality of LED filaments are electrically connected in parallel. In other embodiments, the plurality of LED filaments are electrically connected in series. The frame includes a plurality of insulators to form a serial circuit. The plurality of LED filaments are connected in series. The top rail includes a plurality of electrical conductors and a plurality of electrical insulators. The insulator is interposed between the conductors. Likewise, the bottom rail includes a plurality of electrical conductors and a plurality of electrical insulators. The insulator is interposed between the conductors. The frame is configured to form a serial circuit. In some embodiments, the frame includes a plurality of diodes to form a serial circuit.

A spindle is provided to facilitate assembly of the LED filament module. The shape of the spindle depends on the posture the LED filament module is expected to maintain when it is deployed in the LED light bulb. The spindle approximates a truncated cone for constructing LED filament modules. The plurality of LED filaments and the frame are assembled on the lateral surface of the cone. The frame is given shape by pressing the upper rail against the tapered portion of the spindle and by pressing lower rail against the base portion of the spindle. The LED filament is lined up one by one around the cone straddling the upper rail and the lower rail. The LED filament module is constructed with the spindle for using with the LED light bulb. Exactly one opening is left with the circle defined by the upper rail. Exactly one opening is left with the circle defined by the lower rail. The LED filament module is constructed with the spindle for using with the LED light bulb. Exactly two openings are left in the circle defined by the upper rail. Exactly two openings are left in the circle defined by the lower rail. Exactly one opening is left with the circle defined by the upper rail. However, exactly two openings are left with the circle defined by the lower rail. The LED filament module is mounted within the main chamber of the light transmissive envelope axially around the post portion of the stem press. The LED filament module is kept in position with a plurality of support wires and a plurality of lead wires. The support wire is attached to the tip of the post portion of the stem press at one end and attached to the upper rail of the frame at the other end. The lead wire is attached to the basal portion of the stem press at one end and attached to the lower rail of the frame at the other end. In the embodiment, a pair of the support wires extend diametrically from the tip of the post portion of the stem press. The post portion includes a swollen portion at the top end. The support wire is fixedly embedded in the swollen portion at one end. The support wire includes a hook at the other end. The throat of the hook, facing upwards, is configured to receive the upper rail of the frame in the throat. The left half of the LED filament module is disposed within the left half of main chamber of the light transmissive envelope axially around the post portion of the stem press. The right half of LED filament module is disposed within the right half of main chamber of the light transmissive envelope axially around the post portion of the stem press. The LED filament module is kept in position with a plurality of support wires and a plurality of lead wires. In the embodiment, the left support wire is attached to the tip of the post portion of the stem press at one end and attached to the left upper rail of the frame at the other end. The left lead wire is attached to the basal portion of the stem press at one end and attached to the left upper rail of the frame at the other end. Similarly, the right support wire is attached to the tip of the post portion of the stem press at one end and attached to the right upper rail of the frame at the other end. The right lead wire is attached to the basal portion of the stem press at one end and attached to the right upper rail of the frame at the other end. The LED filament module is mounted within the main chamber of the light transmissive envelope axially around the post portion of the stem press. The LED filament module is kept in position with a plurality of support wires and a plurality of lead wires. In the embodiment, the support wire is attached to the tip of the post portion of the stem press at one end and attached to the upper rail of the frame at the other end. The left lead wire is attached to the basal portion of the stem press at one end and attached to the left lower rail of the frame at the other end. Similarly, the right lead wire is attached to the basal portion of the stem press at one end and attached to the right lower rail of the frame at the other end. In some embodiments, the plurality of lead wires extend vertically to the frame of the LED filament module. In other embodiments, the pair of lead wires project from the basal portion in a V-pattern.

**Claims**

1. A flexible LED filament (400g) configured for emitting omnidirectional light, comprising:

   a linear array of LED chip (402, 404) operably interconnected to emit light upon energization;
   a conductive electrode (410, 412);
   a plurality of conductive wires (440) for electrically connecting the linear array of LED chips and the conductive electrode; and
   a light conversion coating (420) enclosing the linear array of the LED chip and a portion of the conductive electrode, wherein:

      the light conversion layer includes a top layer (420a) and a base layer (420b) interconnecting conformally to form a unitary enclosure;
      the top layer is coated on and contacts the linear array of LED chips, the base layer and the conductive electrode;
      **characterized in that** the base layer includes a phosphor film layer (4201b) and a base transparent layer (4202b), the phosphor film layer being disposed between the linear array of the LED chips and the base transparent layer, the hardness of the phosphor film layer being harder than the base transparent layer, the phosphor film layer comprising phosphors (424'), inorganic oxide nanoparticles (426') and an adhesive binder (422') wherein the amount of the phosphors is greater than the adhesive binder,

the top layer includes a phosphor glue layer (4201a) and a top transparent layer (4202a), the phosphor glue layer being disposed between the linear array of the LED chips and the top transparent layer,

wherein the linear array of LED chips and the conductive electrode are interposed between the base layer and the top layer, and the base layer is harder than the top layer.

2. The LED filament in claim 1, wherein the adhesive binder is made from polyimide and the mass ratio of the adhesive binder in the phosphor film layer is from 5% to 40%.

3. The LED filament in claim 1 or 2, wherein:

the top layer is made from a first adhesive binder doped with phosphor particles and inorganic oxide nanoparticles; and

the base layer is made from a second adhesive binder doped with phosphor particles and inorganic oxide nanoparticles,

wherein the second adhesive binder is harder than the first adhesive binder.

4. The LED filament in claim 3, wherein: the LED filament comprises a first thermal conduction path formed by the contacting phosphor particles and inorganic oxide nanoparticles in the top layer.

5. The LED filament in claim 4, wherein: the first thermal conduction path contacts at least one of a surface of one of the LED chips and a surface of the phosphor glue layer.

6. The LED filament in claim 5, wherein: the first thermal conduction path has an internal end and an external end, the internal end of the first thermal conduction path contacts one of the LED chips, and the external end of the first thermal conduction path contacts the surface of the phosphor glue layer coating away from the LED chips and is exposed from the surface of the phosphor glue layer.

7. The LED filament in claim 6, wherein:

the LED filament comprises a second thermal conduction path formed by the contacting phosphor particles and inorganic oxide nanoparticles in the base layer.

8. The LED filament in claim 7, wherein: the second thermal conduction path contacts at least one of a surface of one of the LED chips and a surface of the phosphor film layer.

9. The LED filament in claim 8, wherein: the second thermal conduction path has an internal end and an external end, the internal end of the second thermal conduction path contacts one of the LED chips, and the external end of the second thermal conduction path contacts the surface of the phosphor film layer away from the LED chips and is exposed from the surface of the phosphor film layer.

10. The LED filament in any one of claims 1 to 9, wherein a surface of the base layer is a successively concave-convex surface and the linear array of the LED chips are laid on the successively concave-convex surface such that two of the LED chips which are disposed on different position of the successively concave-convex surface are oriented towards different directions.

**Patentansprüche**

1. Flexibles LED-Filament (400g), das dafür konfiguriert ist, omnidirektionales Licht zu emittieren und Folgendes umfasst:

eine lineare Anordnung von LED-Chips (402, 404), die funktionsfähig miteinander verbunden sind, um bei Erregung Licht zu emittieren; eine leitende Elektrode (410, 412); eine Vielzahl von leitenden Drähten (440) zum elektrischen Verbinden der linearen Anordnung von LED-Chips und der leitenden Elektrode; und eine Lichtumwandlungsschicht (420), die die lineare Anordnung der LED-Chips und einen Abschnitt der leitfähigen Elektrode umschließt, wobei:

die Lichtumwandlungsschicht eine Deckschicht (420a) und eine Basisschicht (420b) enthält, die konform miteinander verbunden sind, um eine einheitliche Umhüllung zu bilden; die Deckschicht auf die lineare Anordnung von LED-Chips, die Basisschicht und die leitende Elektrode aufgetragen ist und diese kontaktiert; **dadurch gekennzeichnet, dass** die Basisschicht eine Leuchtstofffilmschicht (4201b) und eine transparente Basisschicht (4202b) enthält, wobei die Leuchtstofffilmschicht zwischen der linearen Anordnung der LED-Chips und der transparenten Basisschicht angeordnet ist, die Härte der Leuchtstofffilmschicht härter ist als die transparente Basisschicht, die Leuchtstofffilmschicht Leuchtstoffe (424'), anorganische Oxid-Nanopartikel (426') und ein klebendes Bindemittel (422') umfasst, wobei die Menge der Leuchtstoffe größer ist als die des klebenden Bindemittels,

die obere Schicht eine Leuchtstoffklebeschicht (4201a) und eine obere transparente Schicht (4202a) enthält, wobei die Leuchtstoffklebeschicht zwischen der linearen Anordnung der LED-Chips und der oberen transparenten Schicht angeordnet ist,

wobei die lineare Anordnung der LED-Chips und die leitende Elektrode zwischen der Basisschicht und der oberen Schicht angeordnet sind und die Basisschicht härter ist als die obere Schicht.

2. LED-Filament nach Anspruch 1, wobei das klebende Bindemittel aus Polyamid besteht und der Massenanteil des klebenden Bindemittels in der Leuchtstofffilmschicht zwischen 5 % und 40 % liegt.

3. LED-Filament nach Anspruch 1 oder 2, wobei:

die Deckschicht aus einem ersten klebenden Bindemittel besteht, das mit Leuchtstoffpartikeln und anorganischen Oxid-Nanopartikeln dotiert ist; und
die Basisschicht aus einem zweiten klebenden Bindemittel besteht, das mit Leuchtstoffpartikeln und anorganischen Oxid-Nanopartikeln dotiert ist,
wobei das zweite klebende Bindemittel härter ist als das erste klebende Bindemittel.

4. LED-Filament nach Anspruch 3, wobei:
das LED-Filament einen ersten Wärmeleitpfad umfasst, der durch die sich berührenden Leuchtstoffpartikel und anorganischen Oxid-Nanopartikel in der Deckschicht gebildet wird.

5. LED-Filament nach Anspruch 4, wobei:
der erste Wärmeleitpfad mindestens eine Oberfläche eines der LED-Chips und eine Oberfläche der Leuchtstoffklebeschicht berührt.

6. LED-Filament nach Anspruch 5, wobei:
der erste Wärmeleitpfad ein inneres Ende und ein äußeres Ende aufweist, das innere Ende des ersten Wärmeleitpfades einen der LED-Chips berührt, und das äußere Ende des ersten Wärmeleitpfades die von den LED-Chips entfernte Oberfläche der Leuchtstoffklebeschichtbeschichtung berührt und von der Oberfläche der Leuchtstoffklebeschicht freigelegt ist.

7. LED-Filament nach Anspruch 6, wobei:
das LED-Filament einen zweiten Wärmeleitpfad umfasst, der durch die sich berührenden Leuchtstoffpartikel und anorganischen Oxid-Nanopartikel in der Basisschicht gebildet wird.

8. LED-Filament nach Anspruch 7, wobei:
der zweite Wärmeleitpfad mindestens eine Oberfläche eines der LED-Chips und eine Oberfläche der Leuchtstofffilmschicht berührt.

9. LED-Filament nach Anspruch 8, wobei:
der zweite Wärmeleitpfad ein inneres Ende und ein äußeres Ende aufweist, das innere Ende des zweiten Wärmeleitpfades einen der LED-Chips berührt, und das äußere Ende des zweiten Wärmeleitpfades die von den LED-Chips entfernte Oberfläche der Leuchtstofffilmschicht berührt und von der Oberfläche der Leuchtstofffilmschicht freigelegt ist.

10. LED-Filament nach einem der Ansprüche 1 bis 9, wobei eine Oberfläche der Basisschicht eine sukzessiv konkav-konvexe Oberfläche ist und die lineare Anordnung der LED-Chips auf die sukzessiv konkav-konvexe Oberfläche gelegt ist, so dass zwei der LED-Chips, die an unterschiedlichen Positionen der sukzessiv konkav-konvexen Oberfläche angeordnet sind, in unterschiedliche Richtungen ausgerichtet sind.

## Revendications

1. Filament de DEL flexible (400g) configuré pour émettre une lumière omnidirectionnelle, comprenant :

un réseau linéaire de puces DEL (402, 404) interconnectées de manière fonctionnelle pour émettre de la lumière lors de l'excitation ;
une électrode conductrice (410, 412) ;
une pluralité de fils conducteurs (440) pour connecter électriquement le réseau linéaire de puces DEL et l'électrode conductrice ; et
un revêtement de conversion de lumière (420) entourant le réseau linéaire de puces DEL et une partie de l'électrode conductrice, dans lequel :

la couche de conversion de lumière inclut une couche supérieure (420a) et une couche de base (420b) s'interconnectant de manière conforme pour former une enceinte unitaire ;

la couche supérieure est appliquée sur le réseau linéaire de puces DEL, la couche de base et l'électrode conductrice et entre en contact avec celles-ci ;

**caractérisé en ce que** la couche de base inclut une couche de film luminescent (4201b) et une couche transparente de base (4202b), la couche de film luminescent étant disposée entre le réseau linéaire de puces DEL et la couche transparente de base, la dureté de la couche de film luminescent étant supérieure à celle de la couche transparente de base, la couche de film luminescent comprenant des luminophores (424'), des nanoparticules d'oxyde inorganique (426') et un liant adhésif (422') dans lequel la quantité des luminophores est supérieure à celle du liant adhésif,

la couche supérieure inclut une couche de colle phosphorescente (4201a) et une couche supérieure transparente (4202a), la couche de colle phosphorescente étant disposée entre le réseau linéaire de puces DEL et la couche transparente supérieure,

dans lequel le réseau linéaire de puces DEL et l'électrode conductrice sont interposés entre la couche de base et la couche supérieure, et la couche de base est plus dure que la couche supérieure.

2. Filament de DEL selon la revendication 1, dans lequel le liant adhésif est fabriqué à partir de polyimide et le rapport massique du liant adhésif dans la couche de film luminescent est de 5 % à 40 %.

3. Filament de DEL selon la revendication 1 ou 2, dans lequel :

la couche supérieure est constituée d'un premier liant adhésif dopé avec des particules de phosphore et des nanoparticules d'oxyde inorganique ; et

la couche de base est constituée d'un second liant adhésif dopé par des particules de phosphore et des nanoparticules d'oxyde inorganique,

dans lequel le second liant adhésif est plus dur que le premier liant adhésif.

4. Filament de DEL selon la revendication 3, dans lequel :

le filament de DEL comprend un premier chemin de conduction thermique formé par les particules de phosphore en contact et les nanoparticules d'oxyde inorganique dans la couche supérieure.

5. Filament de DEL selon la revendication 4, dans lequel :

le premier chemin de conduction thermique entre en contact avec au moins une surface de l'une des puces DEL et/ou une surface de la couche de colle phosphorescente.

6. Filament de DEL selon la revendication 5, dans lequel :

le premier chemin de conduction thermique comporte une extrémité interne et une extrémité externe, l'extrémité interne du premier chemin de conduction thermique entre en contact avec l'une des puces DEL, et l'extrémité externe du premier chemin de conduction thermique entre en contact avec la surface du revêtement de couche de colle phosphorescente à l'écart des puces DEL et est exposée à partir de la surface de la couche de colle phosphorescente.

7. Filament de DEL selon la revendication 6, dans lequel :

le filament de DEL comprend un second chemin de conduction thermique formé par la mise en contact de particules de phosphore et de nanoparticules d'oxyde inorganique dans la couche de base.

8. Filament de DEL selon la revendication 7, dans lequel :

le second chemin de conduction thermique entre en contact avec au moins une surface de l'une des puces DEL et/ou une surface de la couche de film phosphorescent.

9. Filament de DEL selon la revendication 8, dans lequel :

le second chemin de conduction thermique comporte une extrémité interne et une extrémité externe, l'extrémité interne du second chemin de conduction thermique entre en contact avec l'une des puces DEL, et l'extrémité externe du second chemin de conduction thermique entre en contact avec la surface de la couche de film phosphorescent à l'écart des puces DEL et est exposée à partir de la surface de la couche de film phosphorescent.

10. Filament de DEL selon l'une quelconque des revendications 1 à 9, dans lequel une surface de la couche de base est une surface successivement concave-convexe et le réseau linéaire de puces DEL est posé sur la surface successivement concave-convexe de telle sorte que deux des puces DEL qui sont disposées sur différentes positions de la surface successivement concave-convexe sont orientées vers des directions différentes.

FIG.1

FIG.2

FIG.3A

FIG.3B

FIG.4

FIG.5

240

244
242

246

FIG.6A

FIG.6B

240a

244a

242a

FIG.7A

FIG.7B

240b

244b

242b

FIG.8A

FIG.8B

FIG.9A

FIG.9B

FIG.9C

FIG.9D

FIG.9E

FIG.10

FIG.11A

FIG.11B

FIG.11C

FIG.11D

FIG.11E

10a

12

100

112

14a

110

14b

19

17

18

16

L2

L1

# FIG.12A

10b

FIG.12B

10c

13B

12

15

100

14b

14a

19a

19

18

16

## FIG.13A

120a 130 120b

15a

100

15

## FIG.13B

10d

12
15
100a
100b

19a
14a
14b

19

H

A
18a

18
16

B

FIG.14A

18a

18b
14a
14b

FIG.14B

400a

410 440 402 404 440 420a 426 424 422 420 412

450 426' 424' 422'

420b

## FIG.17A

400b

410 440 402 405 404 440 420a 426 424 422 420 412

440 402 405 404 440 426 424 422 426' 424' 422' 420

420a 420b

## FIG.17B

FIG.17C

FIG.17D

400e

410  440  402  404  440  426 424 422  420  412

420a

450  426' 424' 422'  426' 424' 422"  4204b  4203b

4203b  4204b

420b

## FIG.17E

400f

410  440  402  404  440  426 424 422  420  412

420a

426' 424' 422'

420b

## FIG.17F

FIG.17G

FIG.22

## REFERENCES CITED IN THE DESCRIPTION

**Patent documents cited in the description**

- CN 105098032
- EP 2535640 A
- CN 105140381
- CN 203367275 U
- US 2013147348 A